(19) Europäisches Patentamt / European Patent Office / Office européen des brevets

(11) **EP 4 144 703 A1**

(12) **EUROPEAN PATENT APPLICATION**

(43) Date of publication:
**08.03.2023 Bulletin 2023/10**

(51) International Patent Classification (IPC):
*C01G 53/00* $^{(2006.01)}$   *H01M 4/525* $^{(2010.01)}$

(21) Application number: **22193247.8**

(22) Date of filing: **31.08.2022**

(52) Cooperative Patent Classification (CPC):
**C01G 53/42; C01G 53/00; H01M 4/525;**
C01P 2002/54; C01P 2002/72; C01P 2002/74;
C01P 2004/50; C01P 2004/51; C01P 2004/61;
C01P 2004/84

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.09.2021 KR 20210116497**

(71) Applicant: **Samsung SDI Co., Ltd.**
**Yongin-si, Gyeonggi-do 17084 (KR)**

(72) Inventors:
• **LEE, Dookyun**
 **17084 Yongin-si (KR)**
• **KANG, Byungwuk**
 **17084 Yongin-si (KR)**

• **KIM, Sungsoo**
 **17084 Yongin-si (KR)**
• **KIM, Saehwan**
 **17084 Yongin-si (KR)**
• **KIM, Soohyeon**
 **17084 Yongin-si (KR)**
• **YOU, Yongchan**
 **17084 Yongin-si (KR)**
• **Jangwook, LEE**
 **17084 Yongin-si (KR)**
• **Minah, CHA**
 **17084 Yongin-si (KR)**
• **CHOI, Seungyeon**
 **17084 Yongin-si (KR)**

(74) Representative: **Marks & Clerk LLP**
 **15 Fetter Lane**
 **London EC4A 1BW (GB)**

(54) **CATHODE ACTIVE MATERIAL FOR LITHIUM SECONDARY BATTERY, METHOD OF PREPARING THE SAME, AND LITHIUM SECONDARY BATTERY INCLUDING CATHODE INCLUDING THE SAME**

(57) Provided are a cathode active material for a lithium secondary battery, a method of preparing the same, and a lithium secondary battery containing a cathode including the cathode active material, in which the cathode active material includes nickel-based lithium metal oxide containing single-crystal particles, wherein a particle size of the single-crystal particles is about 1 $\mu$m to about 8 $\mu$m, and a particle size distribution of the single-crystal particles expressed by (D90-D10)/D50 is 1.4 or less.

FIG. 1

POROUS NICKEL-BASED METAL PRECURSOR → Hollow & Crystallized Secondary Particle (SP) → Surface Defected Primary particle (PP) → SINGLE-CRYSTAL CATHODE ACTIVE MATERIAL (SC)

EP 4 144 703 A1

**Description**

**BACKGROUND**

**1. Field**

One or more embodiments of the present disclosure relate to a cathode active material for a lithium secondary battery, a method of preparing the same, and a lithium secondary battery including a cathode including the same.

**2. Description of the Related Art**

As portable electronic devices and communication devices are advanced, there is a great need to develop lithium secondary batteries having high energy density. However, safety of a lithium secondary battery having high energy density may be reduced, and thus improvement in this regard is needed.

In order to manufacture a lithium secondary battery having a long lifespan and reduced gas, studies have been carried out on the use of a single-crystal cathode active material as a cathode active material for a lithium secondary battery.

However, when a single-crystal cathode active material is prepared, a flux is generally used. When a flux is used, it is necessary to go through a washing process, which is an essential process to remove residual salt. Accordingly, manufacturing costs are increased and preparing processes are complicated. In addition, due to heat treatment at high temperature for single-crystallization, single-crystal cathode active materials may have particle agglomeration or productivity thereof may be reduced.

**SUMMARY**

One or more embodiments of the present disclosure include a cathode active material for a lithium secondary battery, the cathode active material having suppressed or reduced aggregation between particles and excellent structural and morphological stability.

One or more embodiments include a method of preparing the cathode active material.

One or more embodiments include a lithium secondary battery which has improved cycle characteristics due to the inclusion of a cathode including the cathode active material.

Additional aspects of embodiments will be set forth in part in the description which follows and, in part, will be apparent from the description, or may be learned by practice of the presented embodiments of the disclosure.

According to one or more embodiments, a cathode active material for a lithium secondary battery includes

a nickel-based lithium metal oxide containing single-crystal particles, wherein
a particle size of the single-crystal particles is about 1 $\mu$m to about 8 $\mu$m, and
a particle size distribution of the cathode active material expressed by (D90-D10)/D50 is 1.4 or less.

According to one or more embodiments, a method of preparing a cathode active material for a lithium secondary battery includes: obtaining a nickel-based metal precursor having pores therein by a co-precipitation reaction of a nickel precursor and at least one compound selected from the group consisting of an M1 precursor and an M2 precursor, and then drying the resultant;

obtaining a mixture of the nickel-based metal precursor having pores therein and a lithium precursor;
performing a first heat treatment of the mixture to obtain porous oxide particles; and
pulverizing the porous oxide particles, wherein
the M1 precursor is at least one compound selected from a cobalt precursor, a manganese precursor, and an aluminium precursor, and
the M2 precursor is a precursor including at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr).

According to one or more embodiments, a lithium secondary battery includes: a cathode containing the cathode active material; an anode; and an electrolyte therebetween.

At least some of the above and other features of the invention are set out in the claims.

## BRIEF DESCRIPTION OF THE DRAWINGS

The above and other aspects and features of certain embodiments of the disclosure will be more apparent from the following description taken in conjunction with the accompanying drawings, in which:

FIG. 1 schematically shows a process of manufacturing a cathode active material according to an embodiment;

FIG. 2A shows a result of scanning electron microscope (SEM) analysis of the surface of a nickel-based metal precursor prepared according to Preparation Example 1;

FIGS. 2B and 2C show the results of SEM analysis of a cross-section of the nickel-based metal precursor prepared according to Preparation Example 1;

FIG. 2D shows the result of SEM analysis of a cross-section of the nickel-based metal precursor prepared according to Comparative Preparation Example 1;

FIG. 3A shows the result of SEM analysis of the surface of the product obtained after the first heat treatment according to Example 1;

FIG. 3B shows the result of SEM analysis of a cross-section of the product obtained after the first heat treatment according to Example 1;

FIG. 3C shows the result of SEM analysis of a cross-section of the product obtained after the first heat treatment according to Comparative Example 1;

FIG. 4A shows the results of SEM analysis of the surface of the product after pulverizing, according to Example 2;

FIG. 4B shows an enlarged view of a partial area of FIG. 4A;

FIG. 4C shows the results of SEM analysis of the surface of the product after second heat treatment according to Example 2;

FIG. 4D shows the result of Energy Dispersive X-ray Spectroscopy (EDS)-mapping of the cathode active material obtained according to Example 2;

FIG. 5A shows the results of analysis of the particle size distribution characteristics of the cathode active materials prepared according to Example 1 and Comparative Example 1, obtained using a particle size analyzer (PSA);

FIGS. 5B and 5C show the results of analyzing the particle size distribution characteristics of SP, PP, and SC obtained according to each step according to Example 2, obtained using a PSA;

FIGS. 6A and 6B are views showing the results of the charging test for 5 kg of the products of first heat treatment according to Example 1 and Comparative Example 2, respectively;

FIG. 7A shows a view showing a voltage change according to the capacity of a coin half-cell as a result of a mass production test according to Evaluation Example 5;

FIG. 7B shows a view showing the capacity retention ratio characteristics of a coin half-cell as a result of a mass production test according to Evaluation Example 5;

FIG. 8 shows the results of X-ray diffraction (XRD) analysis using X'pert pro (PANalytical) using Cu K$\alpha$ radiation (1.54056Å) for SP, PP, and SC prepared according to Example 2;

FIG. 9 shows the change in capacity retention ratio characteristics in the coin half-cell of Manufacture Example 1 and Comparative Manufacture Example 1;

FIGS. 10A and 10B show SEM images of a cross-section of the cathode before cycle in the cells of Manufacture Example 2 and Comparative Manufacture Example 3, respectively;

FIGS. 10C and 10D show SEM images of a cross-section of the cathode after 200 cycles in the cells of Manufacture Example 2 and Comparative Manufacture Example 3, respectively;

FIGS. 10E and 10F show the results of ex-situ XRD analysis of the (003) peak of each of the cathode active materials in the cathodes Manufacture Example 2 and Comparative Manufacture Example 3 before and after 200 cycles, respectively;

FIGS. 11A and 11B show performance test results of full cells including a PC mixed electrode and an SC mixed electrode in Evaluation Example 8, respectively.

FIGS. 11C and 11D show changes in capacity retention ratio in full cells including a PC mixed electrode and an SC mixed electrode in Evaluation Example 8, respectively;

FIGS. 12A and 12B show the analysis results of the manufacturing process of the SC and PC-blend full cells of Evaluation Example 8, obtained by using in-situ chromatography, respectively; and

FIG. 13 shows a schematic view of a lithium secondary battery according to an embodiment.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein.

Accordingly, the embodiments are merely described below, by referring to the figures, to explain aspects of embodiments of the present disclosure. As used herein, the term "and/or" includes any and all combinations of one or more of the associated listed items. Expressions such as "at least one of," when preceding a list of elements, modify the entire list of elements and do not modify the individual elements of the list.

Hereinafter, a cathode active material for a lithium secondary battery according to an embodiment, a method of preparing the same, and a lithium secondary battery including a cathode including the same will be described in more detail.

In order to manufacture a lithium secondary battery with improved lifespan characteristics, a cathode containing a single-crystal cathode active material is used.

The single-crystal cathode active material has fewer grain boundaries than the polycrystalline cathode active material (or the single-crystal cathode active material has no grain boundaries), so that due to a limited reaction area between the cathode active material and an electrolyte, a negative surface reaction such as formation of a rock salt phase or a side reaction of the cathode active material and the electrolyte can be suppressed or reduced. Therefore, single-crystal cathode active materials may better withstand mechanical stress due to structural change during charge/discharge cycles, compared to polycrystalline cathode active materials.

It is common to use a flux such as NaCl, KCl, or $Na_2SO_4$ when manufacturing a single-crystal cathode active material. However, in the case of using such a flux, it is necessary to go through a washing process which is needed to remove residual salt, resulting in increased preparing costs and a more complicated preparing process. These are obstacles to mass production.

Accordingly, the inventors of the subject matter of the present disclosure developed a method of preparing a single-crystal cathode active material having high crystallinity without using a flux, and a cathode active material obtained using this method. Such a cathode active material has improved structural and morphological stability, and can be mass-produced. In addition, when a cathode containing such a cathode active material is used, safety is improved, and a lithium secondary battery having improved capacity and charge/discharge efficiency can be manufactured.

The cathode active material for a lithium secondary battery according to an embodiment is a nickel-based lithium metal oxide including single-crystal particles, and the particle size of the single-crystal particles is about 1 $\mu$m to about 8 $\mu$m, and the particle size distribution thereof represented by (D90-D10)/D50 is 1.4 or less.

The single-crystal particles used herein refer to i) a one-body particle having a particle size of 1 $\mu$m to 8 $\mu$m, ii) an aggregate of particles, or iii) a mixture of a one-body particle having a particle size of 1 $\mu$m to 8 $\mu$m and an aggregate of particles. In this regard, a particle size of the aggregate of primary particles may be from about 1 $\mu$m to about 8 $\mu$m, and the number of primary particles in the aggregate of primary particles may be 10 or less, for example.

As used herein, the term "one-body particle" refers to a structure in which particles are present as independent phases in which particles do not have the morphology of being aggregated with each other.

The cathode active material according to an embodiment may further include an aggregate of 10 or less primary particles.

The particle size distribution may be, for example, about 1.0 to about 1.4 or from about 1.1 to about 1.3.

D90 may be about 4 $\mu$m to about 7 $\mu$m, and D10 may be about 1.2 $\mu$m to about 2.0 $\mu$m. D50 may be about 2 $\mu$m to about 4 $\mu$m. When D90, D10, and D50 of the cathode active material are outside these ranges, dispersibility may be reduced due to aggregation of the cathode active materials, and the specific surface area may be reduced, thereby reducing activity.

In the present disclosure, when the particles are spherical, "size" or "particle size" indicates the average particle diameter, and when the particles are non-spherical, "size" or "particle size" indicates the longer length (e.g., the longest axis of the particle), for example, the average longer length of the particle. The particle size of the particles can be measured using a scanning electron microscope (SEM) or a particle size analyzer. As the particle size analyzer, for example, a HORIBA, LA-950 laser particle size analyzer may be used. When the particle size is measured using a particle size analyzer, the average particle diameter may be D50. D50 refers to the average diameter of particles when the cumulative percentage reaches 50% by volume in the particle size distribution, and refers to the value of the particle size corresponding to 50% from the smallest particle in the distribution curve accumulated in the order of the smallest particle size to the largest particle size, wherein the total number of particles is 100%.

The average particle diameter of the cathode active material may be measured using, for example, a laser diffraction method, and in more detail, after the cathode active material is dispersed in a solution, the resultant solution is introduced into a commercially available laser diffraction particle size measuring device (for example Microtrac MT 3000) and ultrasonic waves of about 28 kHz are irradiated thereto with an output of 60 W. In this regard, the average particle diameter (D50) when the cumulative percentage reaches 50% of the particle size distribution obtained by the measuring device, may be calculated.

The term "D10," as used herein, refers to the average diameter of particles when the cumulative percentage reaches 10% by volume in the particle size distribution, and the term "D90," as used herein, refers to the average diameter of particles when the cumulative percentage reaches 90% by volume in the particle size distribution.

The particle size of single-crystal particles in the cathode active material according to an embodiment may be, for example, 2 $\mu$m to 6 $\mu$m, 2 $\mu$m to 4 $\mu$m, or 2.5 $\mu$m to 3.5 $\mu$m. When the particle size of the single-crystal particles of the cathode active material is within these ranges, a cathode active material having excellent capacity characteristics may be obtained. In the present disclosure, the particle size may be measured using SEM, BET, and/or the like.

The nickel-based lithium metal oxide may be a compound represented by Formula 1.

$$\text{Formula 1} \qquad Li_a(Ni_{1-x-y}M1_xM2_y)O_{2\pm\alpha1}$$

wherein, in Formula 1, M1 is at least one element selected from Co, Mn, and Al,

M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and
$0.95 \leq a \leq 1.1$, $0.6 \leq (1-x-y) < 1$, $0 \leq x < 0.4$, $0 \leq y < 0.4$, and $0 \leq \alpha1 \leq 0.1$, and a case where both x and y are 0, is excluded.

The nickel-based lithium metal oxide may be, for example, a compound represented by Formula 2.

$$\text{Formula 2} \qquad Li_a(Ni_{1-x-y-z}Co_xM3_yM4_z)O_{2\pm\alpha1}$$

wherein, in Formula 2, M3 is at least one element selected from Mn and Al,

M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and
$0.95 \leq a \leq 1.1$, $0.6 \leq (1-x-y-z) < 1$, $0 \leq x < 0.4$, $0 \leq y < 0.4$, $0 \leq z < 0.4$, $0 \leq \alpha1 \leq 0.1$, and a case where x, y, and z are each 0, is excluded.

The expression "a case where x, y, and z are each 0" represents "a case where x, y, and z are all 0".
The amount of nickel in Formula 2 may be, for example, about 60 mol% to about 95 mol%, or about 80 mol% to about 95 mol% (based on the total amount of metals other than lithium).
The peak intensity ratio $I_{(003)}/I_{(104)}$ measured by X-ray diffraction analysis of the cathode active material for a lithium secondary battery according to an embodiment may be about 1.2 to about 4.0, or about 1.2 to about 2.0.
In X-ray diffraction analysis, the peak intensities I(003) and 1(104) refer to the peak intensity of the (003) plane and the peak intensity of the (104) plane, respectively. In addition, the peak intensity ratio $I_{(003)}/I_{(104)}$ may be a ratio of the peak intensity of the (003) plane to the peak intensity of the (104) plane, and is a parameter made to evaluate the degree of uniform orientation of the crystal grains. From $I_{(003)}/I_{(104)}$, the degree of cation mixing or cation exchange may be evaluated.
The (104) plane is a plane perpendicular (e.g., substantially perpendicular) to the surface of the lithium ion movement path, and as the degree of orientation of the crystal plane of the layered structure is increased, the peak intensity of the (104) plane is decreased. Accordingly, as the degree of orientation is increased, the peak intensity of the (104) plane is decreased and $I_{(003)}/I_{(104)}$ is increased. As the peak intensity ratio $I_{(003)}/I_{(104)}$ increases, the stability of the structure of the cathode active material structure is improved.
In the case of the cathode active material of the present disclosure, $W_{(003)}$ may be about 0.110 to about 0.130, for example, 0.117, and $W_{(104)}$ may be about 0.095 to about 0.145, for example, 0.102. In addition, $W_{(003)}/W_{(104)}$ obtained by X-ray diffraction analysis of the cathode active material may be about 1.01 to about 1.09, about 1.03 to about 1.09, or about 1.03 to about 1.08. For example, it can be seen that crystallinity is improved. In this regard, $W_{(003)}$ represents the full width at half maximum (FWHM) of the peak corresponding to the (003) plane, and $W_{(104)}$ represents the FWHM of the peak corresponding to the (104) plane.
In addition, it can be seen that the cathode active material according to an embodiment is a single-crystal by confirming grains and grain boundaries of a sub-micro scale or higher when the cross-sectional microstructure thereof is identified through a SEM.
When the peak intensity ratios $I_{(003)}/I_{(104)}$, and $W_{(003)}/W_{(104)}$ of the cathode active material according to an embodiment are within these ranges, the stability of the crystal structure of the cathode active material may be improved and the expansion rate and contraction rate according to the insertion/release of lithium may be improved. Accordingly, the capacity characteristics of the lithium secondary battery may be improved.
The cathode active material may further comprises a cobalt compound-containing coating layer on a surface of the nickel-based lithium metal oxide.
The cobalt compound-containing coating layer may coat all or part of the surface of the cathode active material. For example, the coating layer may coat 90% or less, 80% or less, 70% or less, 60% or less, 50% or less, 40% or less, 30% or less, 20% or less, 10% or less, or 1% to 10% of the surface of the cathode active material.

The content of a cobalt compound in the coating layer may be 0.1 mol% to 5.0 mol%, 0.5 mol% to 5.0 mol%, 1 mol% to 4 mol%, or 1.5 mol% to 3 mol% based on the total content (100 mol%) of the cathode active material. When the content of the cobalt compound is within the above range, in the synthesis process of the cathode active material, the reactivity between an electrolyte and the interface of the cathode active material may be decreased by reducing $Ni^{3+}$ included in a metal layer in a large amount into $Ni^{2+}$ and $Co^{4+}$ included in the metal layer in a large amount into $Co^{3+}/Co^{2+}$ or reducing the two types of ions at the same time.

The cobalt compound-containing coating layer may include cobalt oxide, lithium cobalt oxide, or a combination thereof. In addition, the cobalt compound-containing coating layer may further include at least one selected from boron, manganese, phosphorus, aluminium, zinc, zirconium, and titanium.

The coating layer may have a thickness of about 1 nm to about 50 nm, about 5 nm to about 45 nm, or about 10 nm to about 35 nm. When the thickness of the coating layer is within the above range a cathode active material having improved surface resistance characteristics may be obtained.

Hereinafter, a method of preparing a cathode active material for a lithium secondary battery according to an embodiment will be described.

First, a nickel precursor and at least one metal precursor selected from an M1 precursor and an M2 precursor are subjected to a co-precipitation reaction and then dried to obtain a hollow nickel-based metal precursor having pores therein. The nickel-based metal precursor may have amorphous and porous properties, and the nickel-based metal precursor may be a secondary particle, and for example, the particle size of the secondary particle may be 7 $\mu$m to 20 $\mu$m or 10 $\mu$m to 18 $\mu$m, or any ranges subsumed within 7 $\mu$m to 20 $\mu$m. When a nickel-based metal precursor having such a hollow structure is used, the amount of sintering (heat treatment) filling is increased to improve process flow, and mass production yield can be improved.

In the co-precipitation reaction, a complexing agent and a pH-adjusting agent may be used.

The complexing agent may control the reaction rate of the formation of precipitates in the co-precipitation reaction, and may be ammonium hydroxide ($NH_4OH$) (aqueous ammonia), citric acid, or a mixture thereof. The complexing agent may be used at any suitable amount generally used in the art. In one embodiment, aqueous ammonia may be used, for example, as the complexing agent.

The concentration of the complexing agent may be about 0.1 M to about 1.5 M, for example, about 0.1 M to about 1.4 M, or about 0.5 M to about 1.4 M.

The pH-adjusting agent may control the pH of the reaction mixture to form a precipitate from the reaction mixture, and examples thereof include sodium hydroxide (NaOH), sodium carbonate ($Na_2CO_3$), sodium oxalate ($Na_2C_2O_4$), or a mixture thereof. The pH-adjusting agent may be, for example, sodium hydroxide (NaOH).

The M1 precursor is the same as M1 of Formula 1 below, and includes at least one selected from a cobalt precursor, a manganese precursor, and an aluminium precursor. The M2 precursor is the same as M2 of Formula 1 below, and includes at least one selected from boron (B), magnesium (Mg), calcium (Ca), strontium (Sr), barium (Ba), titanium (Ti), vanadium (V), chromium (Cr), iron (Fe), copper (Cu), and zirconium (Zr).

$$\text{Formula 1} \qquad Li_a(Ni_{1-x-y}M1_xM2_y)O_{2\pm\alpha1}$$

wherein, in Formula 1, M1 is at least one element selected from Co, Mn, and Al,

M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and
$0.95 \leq a \leq 1.1$, $0.6 \leq (1-x-y) < 1$, $0 \leq x < 0.4$, $0 \leq y < 0.4$, and $0 \leq \alpha1 \leq 0.1$, and a case where both x and y are 0, is excluded.

The metal precursor may include, for example, at least one compound selected from an aluminium precursor, a cobalt precursor, a manganese precursor, and a metal (M2) precursor.

During the co-precipitation reaction, the pH of the mixture may be adjusted through two steps. The first step may be a pore formation section, in which the pH of the mixture may be controlled to be about 11.5 to about 12.0. The second step may be a particle growth section, and the pH of the mixture may be controlled to be, for example, about 10.5 to about 11.9. The second step is carried out at a pH lower than that of the first step. As described above, by changing a co-precipitation rate, a difference between the synthesis rate of the interior of the nickel-based metal precursor and the synthesis rate of the exterior of the nickel-based metal precursor may be caused to occur. As a result, a nickel-based metal precursor having pores therein may be obtained. In this regard, the nickel-based metal precursor refers to a precursor for obtaining a nickel-based lithium metal oxide.

In the first step, the pH of the mixture may be adjusted to be, for example, in the range of about 11.6 to about 11.9, or about 11.7 to about 11.8. In the second step, the pH of the mixture may be adjusted to be, for example, in the range of about 10.8 to about 11.7, about 11.0 to about 11.7, about 11.2 to about 11.6, or about 11.3 to about 11.6.

The difference between the pH of the second step and the pH of the first step may be in the range of about 0.1 to about 1.5. The difference between the pH of the second step and the pH of the first step may be in the range of, for example, about 0.1 to about 1.0, about 0.1 to about 0.8, about 0.1 to about 0.6, about 0.1 to about 0.5, about 0.1 to about 0.3, or about 0.1 to about 0.2.

The stirring time of the first step may vary depending on, for example, the pH conditions of the first step. In an embodiment, the stirring time may be in the range of, for example, about 8 hours to about 12 hours, or about 9 hours to about 10 hours.

According to the subject matter of the present disclosure, the co-precipitation reaction described above proceeds at a faster rate than a method of preparing a cathode active material precursor of the related art and thus the pore distribution of the core is controlled to be high. Accordingly, a cathode active material can be easily prepared, resulting in high productivity. When the pore distribution is controlled to be high, the number of pores in the cathode active material after heat treatment is increased, so that the cathode active material is easily broken during pressing and excellent electrochemical properties can be exhibited in the cathode. The co-precipitation reaction can be carried out at a high speed by adjusting the stirring time to be short while the stirring speed is high. The nickel-based metal precursor having pores therein is a secondary particle containing a plurality of primary particles, and has a hollow (substantially hollow) structure having pores therein. The particle size of the secondary particles may be, for example, 7 $\mu$m to 20 $\mu$m, 10 $\mu$m to 18 $\mu$m, 12 $\mu$m to 18 $\mu$m, or 12 $\mu$m to 14 $\mu$m.

The particle size of the primary particles may be, for example, 0.2 $\mu$m to 0.3 $\mu$m (200 nm to 300 nm). When the particle sizes of the primary particles and the secondary particles of the nickel-based metal precursor having pores therein are within these ranges, the phase stability of cathode active material may be excellent or at least improved. Thus, the cathode active material having improved capacity characteristics may be obtained.

The nickel-based metal precursor having pores therein exhibits an amorphous characteristic, and contains an interior having pores and an exterior having a denser structure than the interior. The amorphous properties of the nickel-based metal precursor can be confirmed by X-ray diffraction analysis.

The term "interior," as used herein, of the nickel-based metal precursor refers to a pore region in which a plurality of pores exist, a region corresponding to 50 % by volume to 70 % by volume, for example, 60 % by volume of the total volume of the precursor from the center to the surface thereof, or the remaining region except for the region (exterior) within 3 $\mu$m from the outermost surface of the nickel-based metal precursor.

According to an embodiment, the interior of the nickel-based metal precursor has a pore region containing pores, and the pore region may have the longer length of, for example, 2 $\mu$m to 7 $\mu$m, for example, 3.5 $\mu$m to 5 $\mu$m.

The product obtained according to the co-precipitation reaction is dried, thereby obtaining a target nickel-based metal precursor. In this regard, the drying is performed under any suitable conditions generally used in the art. The product obtained according to the co-precipitation reaction may also be cleaned (e.g. washed with distilled water), before being dried.

The nickel precursor and at least one metal precursor of the M1 precursor and the M2 precursor may include, for example, a nickel precursor, a manganese precursor, and a cobalt precursor. In an embodiment, the metal precursor may include, for example, a nickel precursor, a cobalt precursor, and an aluminium precursor.

Examples of the nickel precursor are $Ni(OH)_2$, $NiO$, $NiOOH$, $NiCO_3 \cdot 2Ni(OH)_2 \cdot 4H_2O$, $NiC_2O_4 \cdot 2H_2O$, $Ni(NO_3)_2 \cdot 6H_2O$, $NiSO_4$, $NiSO_4 \cdot 6H_2O$, fatty acid nickel salt, nickel halide, and a combination thereof. Examples of the manganese precursor are: manganese oxides such as $Mn_2O_3$, $MnO_2$, and $Mn_3O_4$; manganese salts such as $MnCO_3$, $Mn(NO_3)_2$, $MnSO_4$, $MnSO_4 \cdot H_2O$, manganese acetate, dicarboxylic acid manganese salt, manganese citrate, and fatty acid manganese salt; a manganese oxyhydroxide; a manganese halide such as manganese chloride; and a combination thereof.

Examples of the cobalt precursor are $Co(OH)_2$, $CoOOH$, $CoO$, $Co_2O_3$, $Co_3O4$, $Co(OCOCH_3)_2 \cdot 4H_2O$, $CoCl_2$, $Co(NO_3)_2 \cdot 6H_2O$, $CoSO_4$, $Co(SO_4)_2 \cdot 7H_2O$, and a combination thereof.

The aluminium precursor may be, for example, aluminium hydroxide, aluminium chloride, aluminium oxide, aluminium sulfate (e.g. $Al_2(SO_4)_3 \cdot 18H_2O$), or a combination thereof.

Regarding the M2 precursor, the precursor containing each element may be a salt, hydroxide, oxyhydroxide, halide, or a combination thereof, each containing each element. In this regard, the salt containing an element may be, for example, at least one compound selected from sulfate, alkoxide, oxalate, phosphate, halide, oxyhalide, sulfide, oxide, peroxide, acetate, nitrate, carbonate, citrate, phthalate, and perchlorate, each including the element described above.

The amount of the nickel precursor and at least one metal precursor selected from the M1 precursor and the M2 precursor may be stoichiometrically controlled to obtain the target nickel-based metal precursor.

The nickel-based metal precursor may be a compound represented by Formula 3, a compound represented by Formula 4, or a combination thereof.

Formula 3 $\qquad (Ni_{1-x-y}M1_xM2_y)(OH)_2$

wherein, in Formula 3, M1 is at least one element selected from Co, Mn, and Al,

M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y) < 1$, $0 \leq x < 0.4$, and $0 \leq y < 0.4$, and a case where both x and y are 0, is excluded,

$$\text{Formula 4} \qquad (Ni_{1-x-y}M1_xM2_y)O$$

wherein, in Formula 4, M1 is at least one element selected from Co, Mn, and Al,
M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y) < 1$, $0 \leq x < 0.4$, and $0 \leq y < 0.4$, and a case where both x and y are 0, is excluded.

The nickel-based metal precursor may be, for example, a compound represented by a compound of Formula 5, a compound of Formula 6, or a combination thereof.

$$\text{Formula 5} \qquad Ni_{1-x-y-z}Co_xM3yM4_z(OH)_2$$

wherein, in Formula 5, M3 is at least one element selected from Mn and Al,

M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, and $0 \leq z < 0.4$, and a case where x, y, and z are each 0, is excluded,

$$\text{Formula 6} \qquad (Ni_{1-x-y-z}Co_xM3yM4_z)O$$

wherein, in Formula 6, M3 is at least one element selected from Mn and Al,
M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, and $0 \leq z < 0.4$, and a case where x, y, and z are each 0, is excluded.

The nickel-based metal precursor may be, for example a compound represented by Formula 7, a compound represented by Formula 8, or a combination thereof.

$$\text{Formula 7} \qquad Ni_{1-x-y-z}Co_xMn_yM4_z(OH)_2$$

wherein, in Formula 7, M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, and $0 \leq z < 0.4$, and a case where x, y, and z are each 0, is excluded,

$$\text{Formula 8} \qquad (Ni_{1-x-y-z}Co_xAl_yM4_z)O$$

wherein, in Formula 8, M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, $0 \leq z < 0.4$, and a case where x, y, and z are each 0, is excluded.

Then, the nickel-based metal precursor having pores therein is mixed with the lithium precursor to obtain a mixture.

The mixing ratio of the lithium precursor and the nickel-based metal precursor may be stoichiometrically adjusted to prepare a desired cathode active material.

The mixture is subjected to a first heat treatment to obtain oxide particles having a porous structure. Phase change and grain growth occur through the first heat treatment.

Then, the oxide particles having a porous structure obtained through the first heat treatment are subjected to a pulverizing process to control the particle size distribution to be 1.4 or less, thereby preparing a cathode active material according to an embodiment. The particle size may be controlled to be 10 μm or less, for example, 1 μm to 10 μm, or 1 μm to 8 μm through the pulverizing process described above.

The method of preparing a cathode active material according to an embodiment may further include a second heat treatment. The second heat treatment may contribute to the formation of a cathode active material having higher crystallinity.

The first heat treatment may be performed at a higher temperature than the second heat treatment. When the first heat treatment is performed at a higher temperature than the second heat treatment, a single-crystal cathode active material with improved phase stability can be obtained.

Secondary particles have strong agglomeration between primary particles, and the term "pulverizing," as used in the present disclosure, refers to a process performed using equipment that applies a strong force (air pressure, mechanical pressure, etc.) to remove the strong agglomeration described above, and examples of the equipment are a jet mill, and an air classifying mill (ACM). When the pulverizing process is performed with a jet mill, the air pressure may be suitably or appropriately adjusted such that the volume density of the pulverized product may be 0.20 g/cm$^3$ to 0.50 g/cm$^3$. The air pressure may be controlled to be, for example, in the range from 2 bar to 8 bar, or from 4 bar to 6 bar.

The term pulverization, as used herein, is a term distinct from crushing, and refers to grinding of, for example, powder (particle size: 1 mm or less) into micro-scale particles (particle size: 10 μm or less). In contrast, the term crushing, as used herein, may refer to breaking up a solid (particle size: 10 mm or more) into a powder (particle size: 1 mm or less).

The nickel-based metal precursor and the lithium precursor may be mixed such that a molar ratio (Li/Me) of Li to a metal other than Li is 0.9 or more and less than 1.1, more than 1.0 and less than 1.1, 1.01 to 1.06, or 1.02 to 1.04.

The lithium precursor may be lithium hydroxide, lithium carbonate, lithium sulfate, lithium nitrate, or a combination thereof.

The first heat treatment may be performed in an oxidizing gas atmosphere, at a temperature of 800 °C to 1200 °C, 900°C to 1100 °C, or 1000 °C to 1200 °C, and the second heat treatment may be performed in an oxidizing gas atmosphere, at a temperature of 600 °C to 900 °C, 650 °C to 850 °C, 650 °C to 800 °C or 650 °C to 750 °C. When the first heat treatment and the second heat treatment are performed under these conditions, a high-density and long-life lithium secondary battery can be manufactured.

The time of the first heat treatment varies depending on the temperature of the first heat treatment, and may be, for example, from 8 hours to 20 hours.

The oxidizing gas atmosphere uses an oxidizing gas such as oxygen or air, and, for example, the oxidizing gas atmosphere includes or consists of a gas atmosphere containing 90% by volume or more of oxygen.

The nickel-based metal precursor and the lithium precursor may be mixed by dry mixing, and may be performed using a mixer or the like. The dry mixing may be performed by milling. Milling conditions are not particularly limited, and may be carried out such that there is little deformation such as micronization of each precursor used as a starting material.

The particle size of the lithium precursor mixed with the nickel-based metal precursor may be controlled in advance. The particle size (e.g., average particle diameter) of the lithium precursor may be in the range of 5 μm to 15 μm. In an embodiment, the particle size of the lithium precursor may be about 10 μm. A target mixture may be obtained by milling a lithium precursor having this particle size with a nickel-based lithium metal oxide precursor at 300 to 3,000 rpm. When the temperature in the mixer rises to about 30 °C or higher in the milling process, a cooling process may be performed to maintain the temperature in the mixer at room temperature (25 °C).

After the pulverizing, the method may further comprise obtaining a mixture by adding a cobalt precursor to a pulverized product. The cobalt precursor may be used when forming a cobalt compound-containing coating layer on the surface of the nickel-based lithium metal oxide. The cobalt precursor may be $Co(OH)_2$, CoOOH, CoO, $Co_2O_3$, $Co_3O_4$, $Co(OCOCH_3)_2 \cdot 4H_2O$, $CoCl_2$, $CO(NO_3)_2 \cdot 6H_2O$, $CoSO_4$, $Co(SO_4)_2 \cdot 7H_2O$, or a combination thereof.

The nickel-based metal precursor may be, for example, $Ni_{0.94}Co_{0.05}Mn_{0.01}(OH)_2$, $Ni_{0.94}Co_{0.05}Al_{0.01}(OH)_2$, $Ni_{0.92}Co_{0.05}Al_{0.03}O_2$, $Ni_{0.94}Co_{0.03}Al_{0.03}(OH)_2$, $Ni_{0.88}Co_{0.06}Al_{0.06}(OH)_2$, $Ni_{0.96}Co_{0.02}Al_{0.02}(OH)_2$, $Ni_{0.93}Co_{0.04}Al_{0.03}(OH)_2$, $Ni_{0.8}CO_{0.15}Al_{0.05}O_2(OH)_2$, $Ni_{0.75}CO_{0.20}Al_{0.05}(OH)_2$, $Ni_{0.92}Co_{0.05}Mn_{0.03}(OH)_2$, $Ni_{0.94}Co_{0.03}Mn_{0.03}(OH)_2$, $Ni_{0.88}CO_{0.06}Mn_{0.06}(OH)_2$, $Ni_{0.96}CO_{0.02}Mn_{0.02}(OH)_2$, $Ni_{0.93}Co_{0.04}Mn_{0.03}(OH)_2$, $Ni_{0.8}Co_{0.05}Mn_{0.05}(OH)_2$, $Ni_{0.75}Co_{0.20}Mn_{0.05}(OH)_2$, $Ni_{0.6}Co_{0.2}Mn_{0.2}(OH)_2$, $Ni_{0.7}Co_{0.15}Mn_{0.15}(OH)_2$, $Ni_{0.7}Co_{0.1}Mn_{0.2}(OH)_2$, $Ni_{0.8}Co_{0.1}Mn_{0.1}(OH)_2$, or $Ni_{0.85}Co_{0.1}Al_{0.05}(OH)_2$.

In an embodiment, the nickel-based lithium metal oxide may be, for example, $LiNi_{0.94}Co_{0.05}Mn_{0.01}O_2$, $Li_{1.05}Ni_{0.94}Co_{0.05}Al_{0.01}O_2$, $Li_{1.05}Ni_{0.92}Co_{0.05}Al_{0.03}O_2$, $Li_{1.05}Ni_{0.94}Co_{0.03}Al_{0.03}O_2$, $Li_{1.05}Ni_{0.88}Co_{0.06}Al_{0.06}O_2$, $Li_{1.05}Ni_{0.96}Co_{0.02}Al_{0.02}O_2$, $Li_{1.05}Ni_{0.93}Co_{0.04}Al_{0.03}O_2$, $Li_{1.05}Ni_{0.8}Co_{0.15}Al_{0.05}O_2$, $Li_{1.05}Ni_{0.75}Co_{0.20}Al_{0.05}O_2$, $Li_{1.05}Ni_{0.92}Co_{0.05}Mn_{0.03}O_2$, $Li_{1.05}Ni_{0.94}Co_{0.03}Mn_{0.03}O_2$, $Li_{1.05}Ni_{0.88}Co_{0.06}Mn_{0.06}O_2$, $Li_{1.05}Ni_{0.96}CO_{0.02}Mn_{0.02}O_2$, $Li_{1.05}Ni_{0.93}Co_{0.04}Mn_{0.03}O_2$, $Li_{1.05}Ni_{0.8}Co_{0.15}Mn_{0.05}O_2$, $Li_{1.05}Ni_{0.75}Co_{0.20}Mn_{0.05}O_2$, $Li_{1.05}Ni_{0.6}Co_{0.2}Mn_{0.2}O_2$, $Li_{1.05}Ni_{0.7}Co_{0.15}Mn_{0.15}O_2$, $Li_{1.05}Ni_{0.7}Co_{0.1}Mn_{0.2}O_2$, $Li_{1.05}Ni_{0.8}Co_{0.1}Mn_{0.1}O_2$, or $Li_{1.05}Ni_{0.85}Co_{0.1}Al_{0.05}O_2$.

Another aspect of embodiments of the present disclosure provides a cathode for a lithium secondary battery, the cathode including a cathode current collector and the cathode active material.

Another aspect of embodiments of the present disclosure provides a lithium secondary battery including a cathode, an anode, and an electrolyte therebetween.

By using the method for preparing a cathode active material according to an embodiment, aggregation between particles may be suppressed or reduced and productivity may be increased, and a single-crystal cathode active material may be prepared. By using the cathode active material, a lithium secondary battery with increased density and prolonged lifespan may be manufactured.

Hereinafter, a method of manufacturing a lithium secondary battery including a cathode including a cathode active material according to an embodiment, an anode, a lithium salt-containing non-aqueous electrolyte, and a separator will be described.

The cathode and the anode are prepared by applying and drying a composition for a cathode active material layer and a composition for an anode active material layer on a cathode current collector and an anode current collector to form a cathode active material layer and an anode active material layer, respectively.

A composition for forming the cathode active material layer may be prepared by mixing a cathode active material, a conductive agent, a binder, and a solvent. As the cathode active material, a nickel-based lithium metal oxide according to an embodiment may be used.

The binder in the cathode improves the adhesive strength between cathode active material particles and between the cathode active material and the cathode current collector. Examples of the binder may be polyvinylidene fluoride (PVDF), polyvinylidene fluoride and hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, tetrafluoroethylene, polyethylene, polypropylene, ethylene-propylene-diene monomer (EPDM) rubber, sulfonated-EPDM rubber, styrene-butadiene rubber (SBR), fluorine rubber, and various suitable copolymers thereof, and these compounds may be used either alone as one type or as a mixture of two or more types. The amount of the binder may be from about 1 part by weight to about 5 parts by weight based on 100 parts by weight of the total weight of the cathode active material. When the amount of the binder is within this range, the binding force of a cathode active material layer with respect to a cathode current collector may be suitable or sufficient.

The conducting agent may be any suitable material as long as it has electrical conductivity without causing a chemical change (e.g., substantially without causing an undesirable chemical change) in the corresponding battery. Examples of the conducting agent may be: graphite such as natural graphite or artificial graphite; a carbonaceous material such as carbon black, acetylene black, ketjen black, channel black, furnace black, lamp black, or thermal black; conductive fiber such as carbon fiber or metal fiber; fluorocarbon; metal powder such as aluminium powder or nickel powder; conductive whiskers such as zinc oxide or potassium titanate; conductive metal oxide such as titanium oxide; and a conductive material such as a polyphenylene derivative.

An amount of the conducting agent may be in a range of about 1 part to about 10 parts by weight or about 1 part to about 5 parts by weight based on 100 parts by weight of the cathode active material. When the amount of the conducting agent is within these ranges, conductivity characteristics of the final cathode thus obtained may be excellent or at least improved.

A non-limiting example of the solvent may be N-methylpyrrolidone, and an amount of the solvent may be in a range of about 20 parts to about 200 parts by weight based on 100 parts by weight of the cathode active material. When the amount of the solvent is within this range, a process for forming the cathode active material layer may be easily carried out.

A thickness of a cathode current collector may be in a range of about 3 $\mu$m to about 500 $\mu$m. A material of the cathode current collector is not particularly limited as long as it has electrical conductivity without causing a chemical change in the corresponding battery. Examples of the material of the cathode current collector may be stainless steel, aluminium, nickel, titanium, calcined carbon, and aluminium or stainless steel that is surface treated with carbon, nickel, titanium, or silver. The cathode current collector may have fine irregularities on a surface thereof to enhance adhesive strength to the cathode active material. The cathode current collector may be in various suitable forms, such as a film, a sheet, a foil, a net, a porous structure, a foam structure, or a non-woven structure.

Also, an anode active material, a binder, and a solvent may be mixed to prepare a composition for an anode active material layer.

As the anode active material, a material capable of reversibly intercalating/deintercalating lithium ions, lithium metal, an alloy of lithium metal, a material capable of being doped on and dedoped from lithium, a transition metal oxide, or a combination thereof may be used.

Examples of the material capable of reversibly intercalating/deintercalating lithium ions include a carbon material, such as, a carbon-based anode active material that is generally used in lithium secondary batteries. Examples of carbon-based anode active materials include crystalline carbon, amorphous carbon, or a combination of these. Examples of the crystalline carbon include graphite such as natural graphite or artificial graphite, which is amorphous, plate-like, flake, spherical, or fibrous, and examples of the amorphous carbon include soft carbon or hard carbon, mesophase pitch carbide, and calcined coke.

The alloy of lithium metal may be an alloy of lithium and a metal selected from Na, K, Rb, Cs, Fr, Be, Mg, Ca, Sr, Si, Sb, Pb, In, Zn, Ba, Ra, Ge, Al, and Sn.

The material capable of being doped on and dedoped from lithium may be a silicon-based material, for example, Si, $SiO_x$ (0 < x < 2), a Si-Q alloy (wherein Q may be an element selected from an alkali metal, an alkaline earth metal, a Group 13 element, a Group 14 element excluding Si, a Group 15 element, a Group 16 element, a transition metal, a rare earth element, and a combination thereof,), a Si-carbon composite, Sn, $SnO_2$, Sn-R (wherein R may be an element selected from an alkali metal, an alkaline earth metal, a Group 13 element, a Group 14 element, a Group 15 element, a Group 16 element, a transition metal, a rare earth element, and a combination thereof, and may not be Sn), or a Sn-carbon composite, etc. In an embodiment, at least one of these and $SiO_2$ may be mixed and used. The elements Q and R may be selected from Mg, Ca, Sr, Ba, Ra, Sc, Y, Ti, Zr, Hf, Rf, V, Nb, Ta, Db, Cr, Mo, W, Sg, Tc, Re, Bh, Fe, Pb, Ru, Os, Hs, Rh, Ir, Pd, Pt, Cu, Ag, Au, Zn, Cd, B, Al, Ga, Sn, In, Ge, P, As, Sb, Bi, S, Se, Te, Po, and combinations thereof.

Lithium titanium oxide may be used as the transition metal oxide.

Non-limiting examples of an anode binder are polyvinylidene fluoride-hexafluoropropylene copolymer (PVDF-co-HFP), polyvinylidenefluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, polyacrylic acid, ethylene-propylene-diene monomer (EPDM), sulfonated EPDM, styrene butadiene rubber (SBR), fluororubber, and polyacrylic acid, and various suitable binder polymers and/or copolymers, which are prepared by substituting hydrogen of these compounds with Li, Na, or Ca.

An anode active material layer may further include a thickening agent.

As the thickening agent, at least one of carboxymethyl cellulose (CMC), carboxyethyl cellulose, starches, regenerated cellulose, ethyl cellulose, hydroxylmethyl cellulose, hydroxyethyl cellulose, hydroxypropyl cellulose, and polyvinyl alcohol may be used. For example, the thickening agent may be CMC.

An amount of the solvent may be in a range of about 100 parts to about 300 parts by weight based on 100 parts by weight of the total weight of the anode active material. When the amount of the solvent is within this range, a process for forming the anode active material layer may be easily carried out.

The anode active material layer does not need a conductive agent when conductivity is ensured. However, the anode active material layer may further include a conductive agent if necessary to achieve suitable properties.

The conducting agent may be any suitable material as long as it has electrical conductivity without causing a chemical change (e.g., substantially without causing an undesirable chemical change) in the corresponding battery. Examples of the conducting agent may be: graphite such as natural graphite and artificial graphite; a carbonaceous material such as carbon black, acetylene black, ketjen black, channel black, furnace black, lamp black, and thermal black; conductive fiber such as carbon fiber and metal fiber; fluorocarbon; metal powder such as aluminium powder and nickel powder; conductive whiskers such as zinc oxide and potassium titanate; conductive metal oxide such as titanium oxide; and conductive agent such as polyphenylene derivatives. The conductive agent may be, for example, carbon black.

When the anode active material layer includes a conductive agent, the amount of the conductive material may be from about 0.01 parts by weight to about 10 parts by weight, about 0.01 parts by weight to about 5 parts by weight, or about 0.1 parts by weight to about 2 parts by weight, based on the total weight of 100 parts by weight of the anode active material layer.

A thickness of an anode current collector may be, for example, in a range of about 3 $\mu$m to about 500 $\mu$m. A material of the anode current collector is not particularly limited as long as it has electrical conductivity without causing a chemical change in the corresponding battery. Examples of the material of the anode current collector are copper, stainless steel, aluminium, nickel, titanium, calcined carbon, copper or stainless steel that is surface treated with carbon, nickel, titanium, or silver, and an aluminium-cadmium alloy. Also, similar to the cathode current collector, the anode current collector may have fine irregularities on a surface thereof to enhance adhesive strength to the anode active material. The anode current collector may be in various suitable forms, such as a film, a sheet, a foil, a net, a porous structure, a foam structure, or a non-woven structure.

A separator may be located between the cathode and the anode prepared as described above.

The separator may have a pore diameter in a range, for example, of about 0.01 $\mu$m to about 10 $\mu$m and a thickness in a range of about 5 $\mu$m to about 30 $\mu$m. Examples of the separator may include an olefin-based polymer separator such as polypropylene separator or polyethylene separator; or a sheet or non-woven fabric of glass fibers. When a solid electrolyte such as a polymer is used as an electrolyte, the solid electrolyte may concurrently (e.g., simultaneously) serve as the separator.

The non-aqueous electrolyte including a lithium salt is formed of a non-aqueous electrolyte and a lithium salt. As the non-aqueous electrolyte, a non-aqueous electrolyte solution, an organic solid electrolyte, and an inorganic solid electrolyte may be used.

Examples of the non-aqueous electrolyte solution may be, but are not limited to, any suitable aprotic organic solvent such as N-methyl-2-pyrrolidinone, propylene carbonate, ethylene carbonate, butylene carbonate, dimethyl carbonate, diethyl carbonate, gamma-butyro lactone, 1,2-dimethoxyethane, 2-methyl tetrahydrofuran, dimethylsulfoxide, 1,3-dioxolane, N,N-formamide, N,N-dimethylformamide, dioxolane, acetonitrile, nitromethane, methyl formate, methyl acetate, phosphoric acid triester, trimethoxy methane, dioxolane derivatives, sulfolane, methyl sulfolane, 1,3-dimethyl-2-imidazolidinone, propylene carbonate derivatives, tetrahydrofuran derivatives, ether, methyl propionate, and ethyl propionate.

Examples of the organic solid electrolyte may be, but are not limited to, polyethylene derivatives, polyethylene oxide derivatives, polypropylene oxide derivatives, phosphoric acid ester polymer, polyester sulfide, polyvinyl alcohol, and polyvinylidene fluoride.

Examples of the inorganic solid electrolyte may be, but are not limited to, a nitride of Li; a halide of Li; and a sulfate of Li; such as $Li_3N$, Lil, $Li_5NI_2$, $Li_3N$-Lil-LiOH, $Li_2SiS_3$, $Li_4SiO_4$, $Li_4SiO_4$-Lil-LiOH, and $Li_3PO_4$-$Li_2S$-$SiS_2$.

The lithium salt may be a material easily dissolved in the non-aqueous electrolyte, for example, but is not limited to, LiCl, LiBr, Lil, $LiClO_4$, $LiBF_4$, $LiB_{10}Cl_{10}$, $LiPF_6$, $LiCF_3SO_3$, $LiCF_3CO_2$, $LiASF_6$, $LiSbF_6$, $LiAlCl_4$, $CH_3SO_3Li$, $(CF_3SO_2)_2NLi$, $(FSO_2)_2NLi$, lithium chloroborate, or a combination thereof.

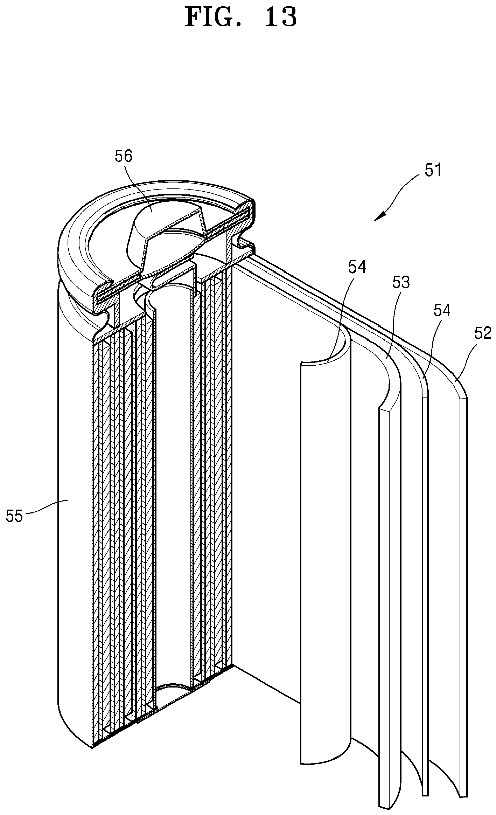

FIG. 13 is a cross-sectional view schematically illustrating a representative structure of a lithium secondary battery 51 according to an embodiment.

Referring to FIG. 13, the lithium secondary battery 51 includes a cathode 53 according to an embodiment, an anode 52, and a separator 54. The cathode 53 contains the cathode active material according to an embodiment.

An electrode assembly in which the cathode 53, the anode 52, and the separator 54 are wound or folded, is accommodated in a battery case 55. The separator 54 may be located between the cathode 53 and the anode 52 to form a battery assembly in which the cathode 53, the anode 52, and the separator 54 are alternately stacked according to the shape of the battery 51. Next, an organic electrolyte is injected into the battery case 55 and sealed with a cap assembly 56 to complete the manufacture of the lithium secondary battery 51. The battery case 55 may have a cylindrical, rectangular, or thin-film shape. For example, the lithium secondary battery 51 may be a large-sized thin-film battery. The lithium secondary battery 51 may be a lithium ion battery. Once the battery assembly is accommodated in a pouch, impregnated in an organic electrolyte solution, and sealed, the manufacture of a lithium ion polymer battery may be completed. In addition, a plurality of the battery structures are stacked to form a battery pack, and the battery pack can be used in any suitable device requiring high capacity and high output. For example, the battery pack may be used in laptop computers, smart phones, and electric vehicles.

Also, the lithium secondary battery may be used in electric vehicles (EVs) due to excellent storage stability at high temperature, lifespan characteristics, and highrate characteristics. For example, the lithium secondary battery may be used in hybrid vehicles such as plug-in hybrid electric vehicles (PHEVs).

One or more embodiments will now be described in more detail with reference to the following examples. However, these examples are not intended to limit the scope of the one or more embodiments.

Preparation of nickel-based metal precursor

Preparation Example 1: NCM precursor

A nickel-based metal precursor ($Ni_{0.94}Co_{0.05}Mn_{0.01}(OH)_2$) (NCM precursor) was synthesized through co-precipitation.

Nickel sulfate ($NiSO_4.6H_2O$), cobalt sulfate ($CoSO_4 \cdot 7H_2O$), and manganese sulfate ($MnSO_4 \cdot H_2O$) were dissolved in distilled water, which is a solvent, such that a molar ratio of Ni:Co:Mn was 94:5:1 to prepare a mixed solution. Aqueous ammonia ($NH_4OH$), which is a complexing agent, and sodium hydroxide (NaOH), which is a pH adjuster, were prepared to form a complex compound. The concentration of aqueous ammonia was 0.5 M, and the concentration of sodium hydroxide was 32 wt%. The metal source mixed solution, aqueous ammonia, and sodium hydroxide were added into a reactor. Sodium hydroxide was then added into the reactor to adjust the pH of the inside thereof.

The pH of the mixture was adjusted to be 11.75 and stirred for 10 hours, and then the pH of the mixture was adjusted to be 11.55 and stirred for 25 hours to reduce the pH by about 0.2 based on the initial pH. In this way, by changing the co-precipitation rate of the nickel-based lithium metal oxide precursor, the difference was caused to occur between the synthesis rate of the interior of the nickel-based metal precursor and the exterior thereof, thereby obtaining a nickel-based metal precursor having pores therein.

After the reaction was carried out for about 20 hours while stirring the reaction mixture, the input of the raw material solution was stopped.

The slurry solution in the reactor was filtered and washed with distilled water of high purity and dried in a hot air oven at 200 °C for 24 hours to obtain a nickel-based metal precursor ($Ni_{0.94}Co_{0.05}Mn_{0.01}(OH)_2$) having a hollow structure. The nickel-based metal precursor is a secondary particle that is an aggregate of primary particles, and the particle size of the primary particles was about 300 nm (0.3 $\mu$m), and the average particle diameter of the secondary particles was about 14 $\mu$m.

Preparation Example 2: NCA precursor

A nickel-based metal precursor ($Ni_{0.94}Co_{0.05}Al_{0.01}(OH)_2$) (NCA precursor) was synthesized through co-precipitation.

A nickel-based metal precursor ($Ni_{0.94}CO_{0.05}Al_{0.01}(OH)_2$) having a hollow structure was obtained in the same manner as in Preparation Example 1, except that aluminium sulfate ($Al_2(SO_4)_3 \cdot 18H_2O$) was used instead of manganese sulfate in preparing the mixed solution. The nickel-based metal precursor is a secondary particle that is an aggregate of primary particles, and the particle size of the primary particles was about 300 nm (0.3 $\mu$m), and the average particle diameter of the secondary particles was about 14 $\mu$m.

Comparative Preparation Example 1: Non-hollow, high-density, large-grain NCM precursor

A large-grain nickel-based metal precursor that had a dense state and did not have a hollow structure was obtained in the same manner as in Preparation Example 1, except that the pH of the mixture was maintained at 11.77 and stirred for a total of 35 hours, instead of reducing the pH of the mixture by about 0.2 based on the initial pH in such a manner that the pH of the mixture was adjusted to be 11.75 and then stirred for 10 hours, and then, the pH of the mixture was adjusted to be 11.55 and stirred for 25 hours. The nickel-based metal precursor obtained according to Comparative Preparation Example 1 is a secondary particle that is an aggregate of primary particles, and the particle size of the primary particles was about 300 nm (0.3 $\mu$m), and the average particle diameter of the secondary particles was about 14 $\mu$m. Comparative Preparation Example 2: Non-hollow, high-density, large-grain NCA precursor

A large particle nickel-based metal precursor that had a high-density state and did not have a hollow structure, was obtained in the same manner as in Preparation Example 2, except that the pH of the mixture was maintained at 11.77 and stirred for a total of 35 hours, instead of reducing the pH of the mixture by about 0.2 based on the initial pH in such a manner that the pH of the mixture was adjusted to be 11.75 and then stirred for 10 hours, and then, the pH of the mixture was adjusted to be 11.55 and stirred for 25 hours. The nickel-based metal precursor obtained according to Comparative Preparation Example 2 is a secondary particle that is an aggregate of primary particles, and the particle size of the primary particles was about 300 nm (0.3 $\mu$m), and the average particle diameter of the secondary particles was about 14 $\mu$m. Comparative Preparation Example 3: small particle, high-density, and non-hollow NCM precursor

A high-density small particle nickel-based metal precursor having a dense state without a hollow structure was obtained in the same manner as in Comparative Preparation Example 1, except that the pH of the mixture was increased from 11.77 to 12.2. The average particle diameter of the secondary particles of the small particle nickel-based metal precursor was about 3 $\mu$m.

Manufacture of cathode active material for lithium secondary battery

Example 1: NCM + (No cobalt compound-containing coating layer)

The porous nickel-based metal precursor ($Ni_{0.94}Co_{0.05}Mn_{0.01}(OH)_2$) having a hollow structure of Preparation Example 1 and lithium hydroxide were added to obtain a first mixture. The molar ratio (Li/Me) of Li to the metal other than Li in the first mixture was about 1.02. In this regard, the amount of metal (Me) was the total amount of Ni, Co and Mn.

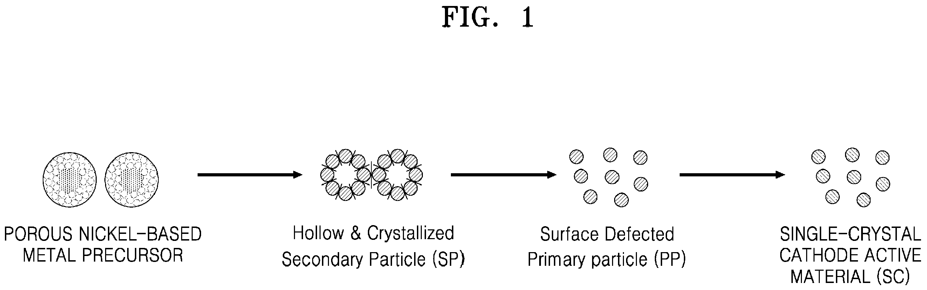

The first mixture was subjected to a first heat treatment at 900 °C in an air atmosphere for 15 hours to prepare hollow and crystallized secondary particles (SP) (see, for example, FIG. 1). Through the first heat treatment, Ni antisite was formed in the bulk structure and nickel was diffused to the surface to form NiO phase that is irreversible in terms of electrochemical activity.

The first heat treatment product was pulverized by using a jet mill to obtain pulverized particles having a particle size of 3 $\mu$m. The air pressure during jet-mill pulverizing was about 5 bar. These particles were surface-defected primary particles (PP) (see FIG. 1). In this regard, surface defects indicate the presence of broken particulates and scratches on the surface.

A single-crystal (SC) cathode active material ($Li_{1.02}Ni_{0.94}Co_{0.05}Mn_{0.01}O_2$) was prepared by performing a second heat treatment on the pulverized particles in an oxygen atmosphere at about 750 °C (see FIG. 1). Through the second heat treatment, the decrease in crystallinity in the grinding process can be recovered, and through this process, the ordering of Ni antisite to metal site was promoted and surface defects were removed.

The particle size (e.g., average particle diameter) of the single-crystal particles (one-body particle or primary particle) of the cathode active material was about 3 $\mu$m, and the single-crystal particles had a non-porous structure.

Example 2: NCA + cobalt compound-containing coating layer

A first mixture was obtained by adding nickel-based metal precursor ($Ni_{0.94}Co_{0.05}Al_{0.01}(OH)_2$) having a hollow structure of Preparation Example 2 and lithium hydroxide. The molar ratio (Li/Me) of Li to the metal other than Li in the first mixture was about 1.02. In this regard, the metal (Me) amount was the total amount of Ni, Co and Al.

The first mixture was subjected to a first heat treatment at 900 °C in the air atmosphere for 15 hours to prepare crystalline secondary particles (SP) having a hollow structure. Through the first heat treatment, Ni antisite was formed in the bulk structure and nickel was diffused to the surface to form NiO phase that is irreversible in terms of electrochemical activity.

The first heat treatment product was pulverized by using a jet mill to obtain pulverized particles having a particle size of 3 $\mu$m. These particles were surface-defected primary particles (PP).

A cathode active material ($LiNi_{0.94}Co_{0.05}Al_{0.01}O_2$) containing a cobalt compound-containing coating layer having a hollow structure was prepared by adding $Co(OH)_2$, which is a cobalt precursor, to the pulverized particles and performing a second heat treatment at about 700 °C in an oxygen atmosphere. The amount of the cobalt precursor was controlled such that the amount of the cobalt compound in the cobalt compound-containing coating layer was 2 mol% based on the total amount of the cathode active material.

The cathode active material obtained according to Example 2 contained single-crystal particles, the particle size of the single-crystal particles was about 3 $\mu$m, and the cathode active material had a non-porous structure. The amount of the cobalt compound was 2 mol% based on the total amount of the cathode active material finally obtained, and the thickness of the cobalt compound-containing coating layer was about 20 nm.

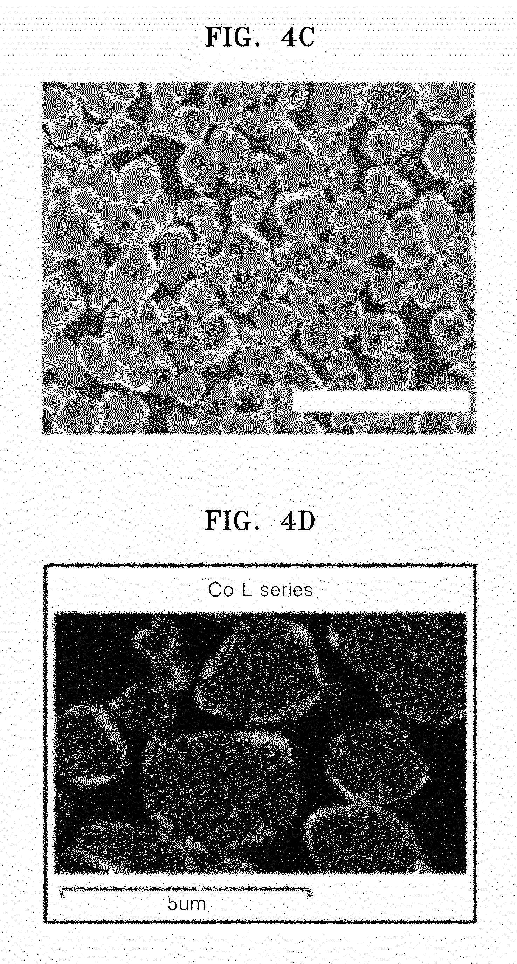

The cobalt compound-containing coating layer improves the surface stability and ionic conductivity of the single-crystal cathode active material, and the presence of the coating layer containing the cobalt compound was confirmed by the EDS-mapping of FIG. 4D.

Example 3

Example 3 relates to a case in which the cathode active material of Example 2 was prepared in lab-scale and mass-scale production (MP), and is an experimental example for mass productivity test of Evaluation Example 5 to be described below.

In the lab-scale experiment, 200 g of precursor was mixed with lithium hydroxide (LiOH) and heat treated in a box-furnace. In the MP scale, 3,000 g of precursor was mixed with LiOH and heat treated in Roller Hearth Kiln (RHK). The precursor used herein was the nickel-based metal precursor ($Ni_{0.94}Co_{0.05}Al_{0.01}(OH)_2$) having a hollow structure used in Example 2.

In the lab-scale test and the MP-scale tests, the first heat-treated mixture SP was pulverized using a jet mill. 200 g of powder was subjected to the second heat treatment in a box furnace to obtain SC-Lab (single-crystal cathode active material prepared in lab-scale test). Then, 3,000 g of powder was subjected to the second heat treatment at RHK to obtain SC-MP(single-crystal cathode active material prepared in mass-scale production test). In Example 3, the conditions for each of the first heat treatment and the second heat treatment were in the same as described in Example 2. Comparative Example 1

A first mixture was obtained by adding nickel-based metal precursor ($Ni_{0.94}Co_{0.05}Mn_{0.01}(OH)_2$) having a non-hollow structure of Comparative Preparation Example 1 and lithium hydroxide. The molar ratio (Li/Me) of Li to the metal other than Li in the first mixture was about 1.02. In this regard, the metal (Me) amount was the total amount of Ni, Co and Mn.

The first mixture was subjected to a first heat treatment in an air atmosphere at 900 °C for 15 hours.

The heat treatment product was pulverized using a Hosogawa jet mill (Blower 35 Hz, AFG 8000 rpm, Air 4 kgf/cm$^2$) to prepare a polycrystalline nickel-based lithium metal oxide having a non-hollow structure.

The pulverized nickel-based lithium metal oxide having a non-hollow structure was subjected to a second heat treatment at about 750 °C in an oxygen atmosphere to obtain a cathode active material which is polycrystalline particles and has a non-hollow structure.

Although the cathode active material obtained according to Comparative Example 1 had the form of pulverized primary particles, the surface thereof had many defects generated in the pulverizing process and the particles were broken. Comparative Example 2

A cathode active material was obtained in the same manner as in Comparative Example 1, except that the small, high-density nickel-based metal precursor of Comparative Preparation Example 3 was used instead of the large nickel-based metal precursor having the non-hollow structure of Comparative Preparation Example 1.

Comparative Example 3

A polycrystalline cathode active material (Poly NCA: PC NCA) was obtained in the same manner as in Comparative Example 1, except that the nickel-based metal precursor ($Ni_{0.94}Co_{0.05}Al_{0.01}(OH)_2$) having the non-hollow structure of Comparative Preparation Example 2 was used instead of the nickel-based metal precursor ($Ni_{0.94}Co_{0.05}Mn_{0.01}(OH)_2$) having the non-hollow structure of Comparative Preparation Example 1. This cathode active material is a secondary particle and has a particle size of about 14 $\mu$m, and the particle size of a primary particle thereof was 500 nm.

The cathode active material obtained according to Comparative Example 3 was in the form of secondary particles which are polycrystalline particles with no hollow structure therein and in which primary particles were dense.

Lithium secondary battery Manufacture Example

Manufacture Example 1: Manufacturing of Coin Half-cell

A coin half-cell was prepared as follows without a separate pulverization process, by using the cathode active material obtained according to Example 1 as a cathode active material.

A mixture of 96 g of the nickel-based active material ($LiNi_{0.94}Co_{0.5}Mn_{0.1}O_2$) prepared in Example 1, 2 g of polyvinylidene fluoride, 47 g of N-methylpyrrolidone as a solvent, and 2 g of carbon black as a conducting agent was mixed by using a mixer to remove bubbles, thereby preparing a slurry for forming a cathode active material layer in which the mixture was homogeneously dispersed.

The slurry prepared according to the process was coated on an aluminium foil using a doctor blade so as to form a thin electrode plate, and the thin electrode plate was dried at 135 °C for 3 hours or more and subjected to pressing and vacuum drying processes, thereby preparing a cathode.

A 2032 type coin half-cell was manufactured using the cathode and a lithium metal counter electrode. A separator having a thickness of about 16 $\mu$m and formed of a porous polyethylene (PE) film was located between the cathode and the lithium metal counter electrode, and an electrolyte was injected to manufacture the 2032 type coin half-cell. A solution in which 1.1 M $LiPF_6$ was dissolved in a solvent prepared by mixing ethylene carbonate (EC) and ethylmethyl carbonate (EMC) at a volume ratio of 3:5 was used as the electrolyte solution.

When a coin half-cell is manufactured according to Manufacture Example 1, it is not necessary to go through a grinding process when manufacturing a cathode, and primary particles that are agglomerated in the pressing process may be dispersed. Therefore, productivity can be improved.

Manufacture Example 2-3: Manufacturing of Coin Half Cells

Coin half cells were manufactured in the same manner as in Manufacture Example 1, except that the cathode active materials of Examples 2 and 3 were used instead of the cathode active material of Example 1.

Comparative Manufacture Example 1: Manufacturing of Coin Half Cell

A coin half-cell was manufactured in the same manner as in Manufacture Example 1, except that the cathode active material obtained according to Comparative Example 1 was used instead of the cathode active material of Example 1. Comparative Manufacture Example 2: Manufacturing of Coin Half Cell

A coin half-cell was manufactured in the same manner as in Comparative Manufacture Example 1 except that the cathode active material of Comparative Example 2 was used instead of the cathode active material of Comparative Example 1. Comparative Manufacture Example 3: Manufacturing of Coin Half Cell

A coin half-cell was manufactured in the same manner as in Comparative Manufacture Example 1 except that the cathode active material of Comparative Example 3 was used instead of the cathode active material of Comparative Example 1.

Evaluation Example 1: Scanning electron microscope

(1) Preparation Example 1 and Comparative Preparation Example 1

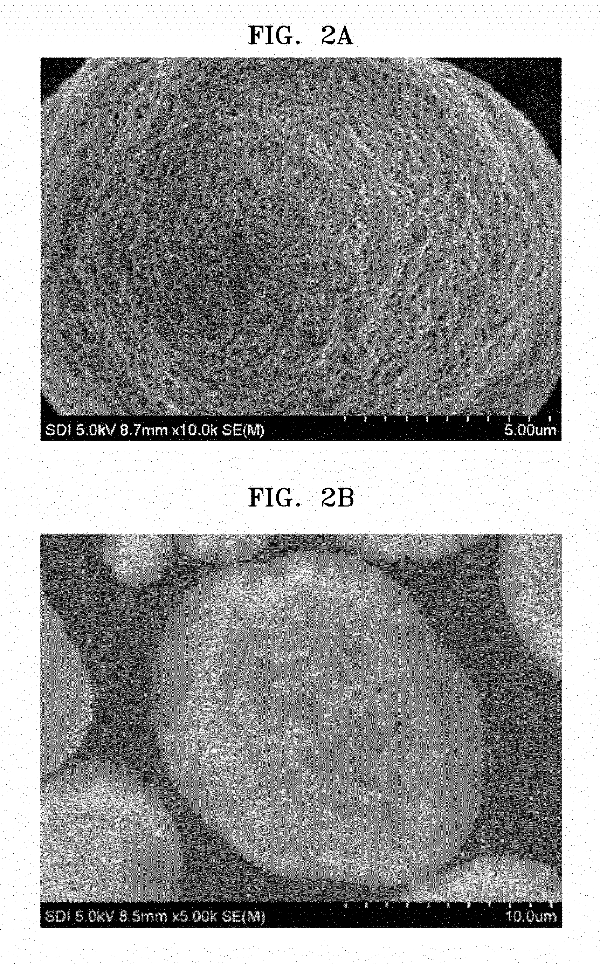

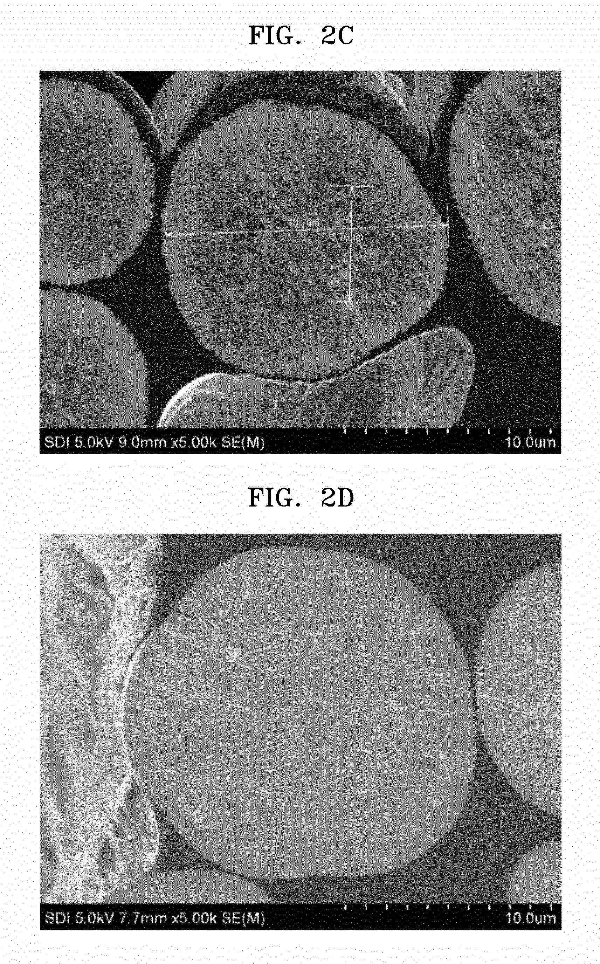

A SEM analysis was performed on the surface and cross-section of each of the nickel-based metal precursors prepared according to Preparation Example 1 and Comparative Preparation Example 1. As the scanning electron microscope, Magellan 400L (FEI company) was used. The SEM analysis result of the surface of the nickel-based metal precursor prepared according to Preparation Example 1 is shown in FIG. 2A, and the SEM analysis result of the cross-section of the nickel-based metal precursor prepared according to Preparation Example 1 is shown in FIGS. 2B and 2C. The SEM analysis result of the cross section of the nickel-based metal precursor of Comparative Preparation Example 1 is shown in FIG. 2D.

Referring to FIG. 2B, the nickel-based metal precursor of Preparation Example 1 has pores, and the primary particle having the particle size of 0.3 $\mu$m (300 nm) and the secondary particle having the particle size of 14 $\mu$m. According to FIG. 2C, the interior (for example, the pore region) in which the pores exist has a longer length of about 5.76 $\mu$m, and shows better amorphous properties.

In contrast, as shown in FIG. 2D, the nickel-based metal precursor of Comparative Preparation Example 1 did not have pores therein, unlike the nickel-based metal precursor of Preparation Example 1.

(2) Example 1 and Comparative Example 1

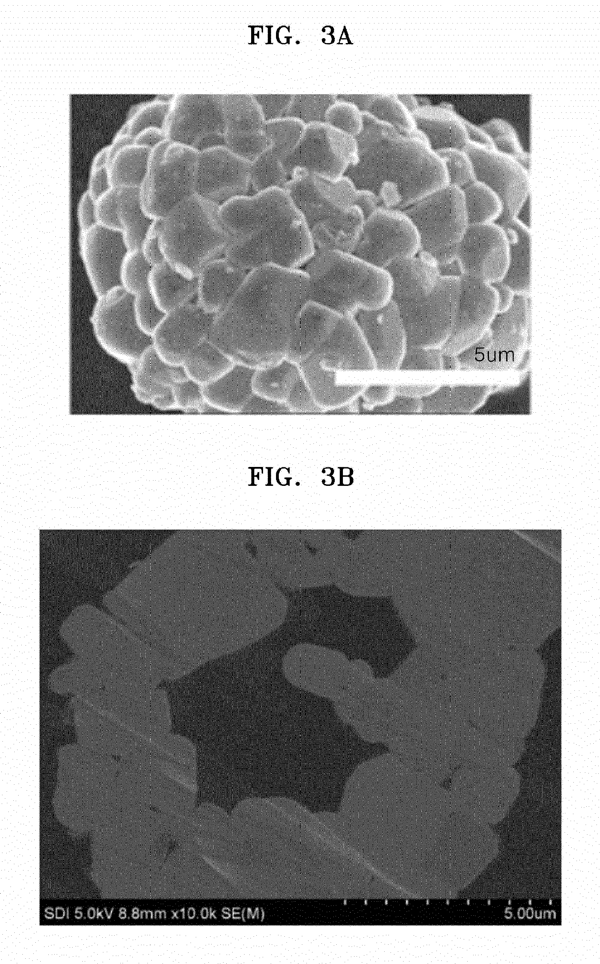

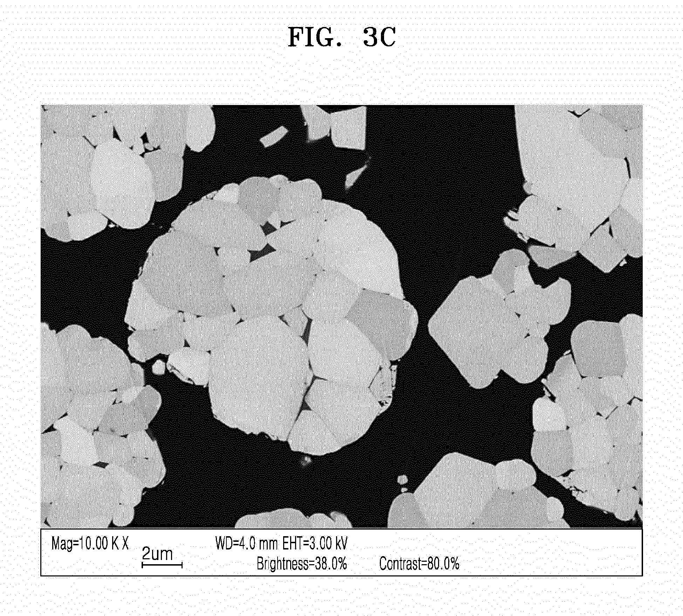

SEM analysis was performed on the product (SP) obtained after the first heat treatment according to Example 1 and Comparative Example 1. The SEM was Magellan 400L (FEI company), and the SEM analysis result of the surface of the product (SP) obtained after the first heat treatment according to Example 1 is shown in FIG. 3A. The SEM analysis result of the cross-section of the product obtained after the first heat treatment according to Example 1 is shown in FIG. 3B. The result of SEM analysis of the cross-section of the product (SP) obtained after the first heat treatment according to Comparative Example 1 is shown in FIG. 3C.

SP of Example 1 was a secondary particle including single-crystal primary particles as shown in FIGS. 3A and 3B, and had a hollow (substantially hollow) structure having pores therein. The particle size of the primary particles was about 3.5 $\mu$m and the particle size of the secondary particles was about 13 $\mu$m.

In contrast, the SP of Comparative Example 1 had the form of small particles (1 $\mu$m-5 $\mu$m) as shown in FIG. 3C and had no pores.

(3) Example 2

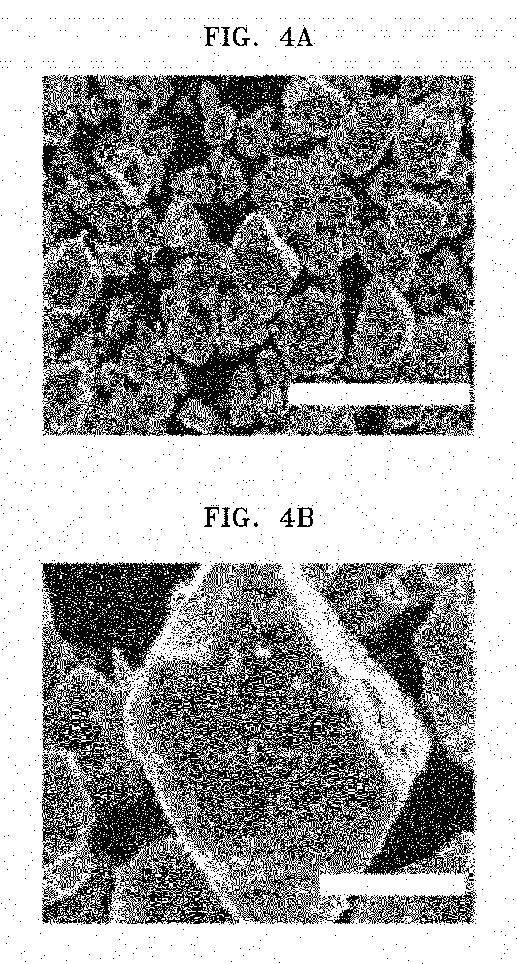

In Example 2, the surface of the post-pulverizing product (PP) and the product after the second heat treatment (SC) was subjected to SEM analysis. The results of surface analysis of the pulverized product (PP) are shown in FIGS. 4A and 4B, respectively. FIG. 4B shows an enlarged view of a partial area of FIG. 4A. The SEM analysis result of the surface of the product (SC) after the second heat treatment is shown in FIG. 4C.

Referring to these figures, Ni antisite was formed in the bulk structure through the first heat treatment and nickel was diffused to the surface to form NiO that is irreversible in terms of electrochemical activity. Due to the second heat treatment, the decrease in crystallinity in the grinding process of the second heat treatment may be recovered, and through this process, the ordering of the Ni antisite into a metal site may be promoted and surface defects may be healed or reduced. The cobalt compound-containing coating layer improves the surface stability and ionic conductivity of the single-crystal cathode active material, and the presence of the coating layer containing the cobalt compound was confirmed by the EDS-mapping of FIG. 4D. Evaluation Example 2: Particle Size Distribution

(1) Example 1 and Comparative Example 1

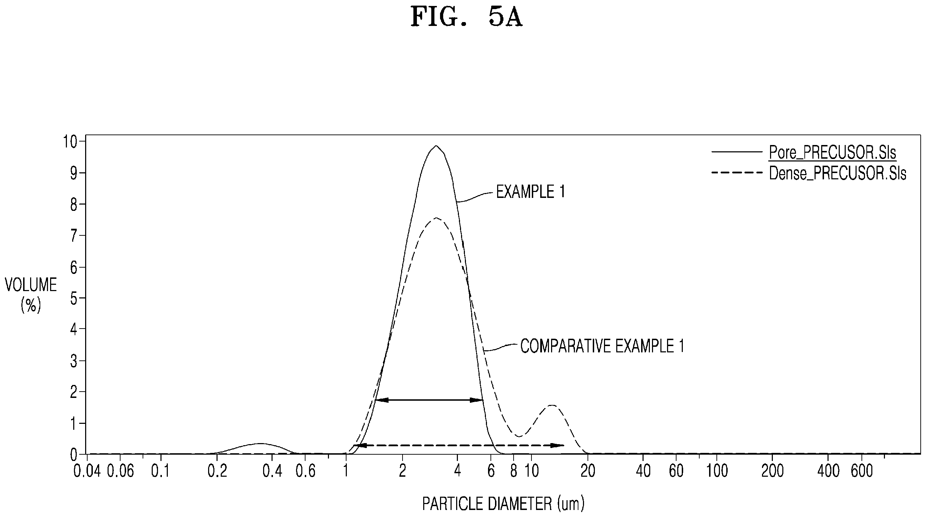

The particle size distribution characteristics of the cathode active materials (SC) prepared according to Example 1 and Comparative Example 1 were analyzed using a particle size analyzer (PSA), and the results thereof are shown in FIG. 5A and Table 1.

In Table 1, particle size distribution (span) is represented by (D90-D10)/D50.

The particle size distribution graph may be obtained by the following PSD (particle size distribution) measurement conditions.

LS13320 (Beckmann Coulter) was used as a laser particle size analyzer, and the analysis conditions were as follows:

pump speed (55%), sample ultrasonic dispersion of 40 KHz ultrasonic wave (60s), run length of 60s, refractive index ratio of Sample RI 1.6, e-factor of 1.00, sample amount of 0.20 g, and 1 ml of sample input dispersant: 10% sodium hexametaphosphate (sodium hexametaphosphate)

Table 1

| Sample | D10 ($\mu$m) | D90 ($\mu$m) | D50 ($\mu$m) | span |
|---|---|---|---|---|
| Example 1 | 1.3 | 4.3 | 2.8 | 1.07 |
| Comparative Example 1 | 0.9 | 5.7 | 3.0 | 1.60 |

Referring to Table 1 and FIG. 5A, it was found that the cathode active material of Example 1 had the particle size distribution (span) of less than 1.4. This result indicates that the cathode active material of Example 1 had a more uniform particle size than the cathode active material of Comparative Example 1.

(2) Example 2

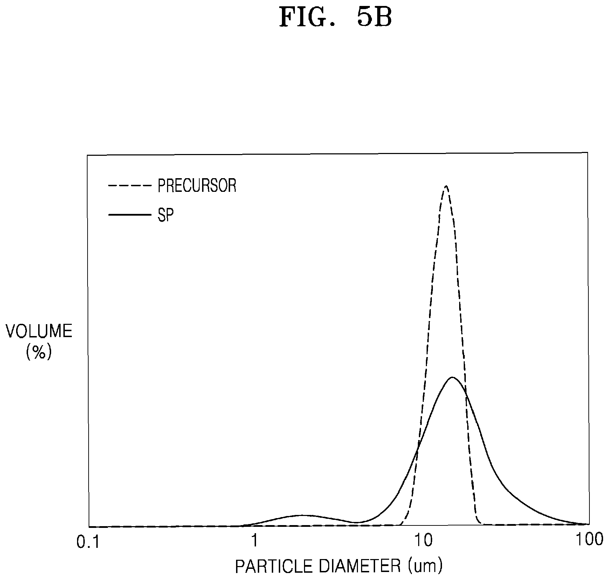

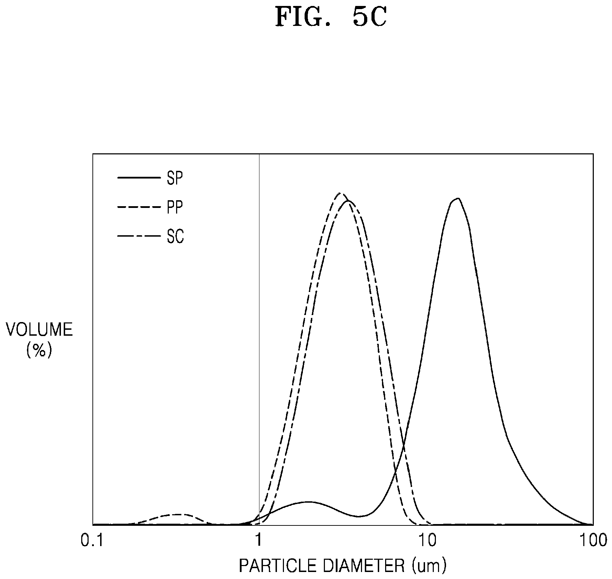

The particle size distribution characteristics of SP, PP, and SC obtained according to each step according to Example 2 were analyzed using a PSA, and the results thereof are shown in Table 2, and FIGS. 5B and 5C. The analysis device and evaluation conditions are the same as those described for Example 1.

Table 2

| Sample | D10($\mu$m) | D50($\mu$m) | D90($\mu$m) | Span |
|---|---|---|---|---|
| Nickel-based metal precursor (NCA(OH)$_2$) | 10.92 | 14.31 | 18.06 | 0.50 |
| SP | 7.25 | 15.50 | 30.18 | 1.48 |
| PP | 1.64 | 3.05 | 5.19 | 1.16 |
| SC | 1.94 | 3.48 | 6.09 | 1.20 |

As shown in Table 2, the span was 1.20, which indicates that SC had a uniform (substantially uniform) particle distribution.

The D50 particle size of the NCA(OH)$_2$ precursor was 14.31 $\mu$m, and the D50 particle size of the product SP obtained after the first heat treatment was slightly increased to 15.50 $\mu$m, and as shown in FIG. 5B, compared to the case of the NCA(OH)$_2$ precursor of FIG. 5A, a broad particle size distribution was obtained. The increase in the D50 particle size of SP is due to the growth of SP particles compared to the case of the precursor. The broadened particle size distribution can be seen from FIG. 5B and the span of Table 2.

The pulverizing of SP into PP can be clearly observed from FIG. 5C. The particle size was greatly reduced after jet milling. From the PSA data, it can be seen that even when pulverizing was performed under harsh conditions using a jet mill, single-crystal grains (primary particles) having a maximum particle size of 3 $\mu$m were obtained.

The particle size distribution of SC NCA was slightly broadened compared to that of PP as shown in FIG. 5C and Table 2. When the second heat treatment was performed at a low temperature of 700 °C or higher, particle agglomeration was suppressed or reduced and the overall particle size (D10, D50, and D90) was slightly increased during the second heat treatment of PP.

Evaluation Example 3: Charging test of product of first heat treatment

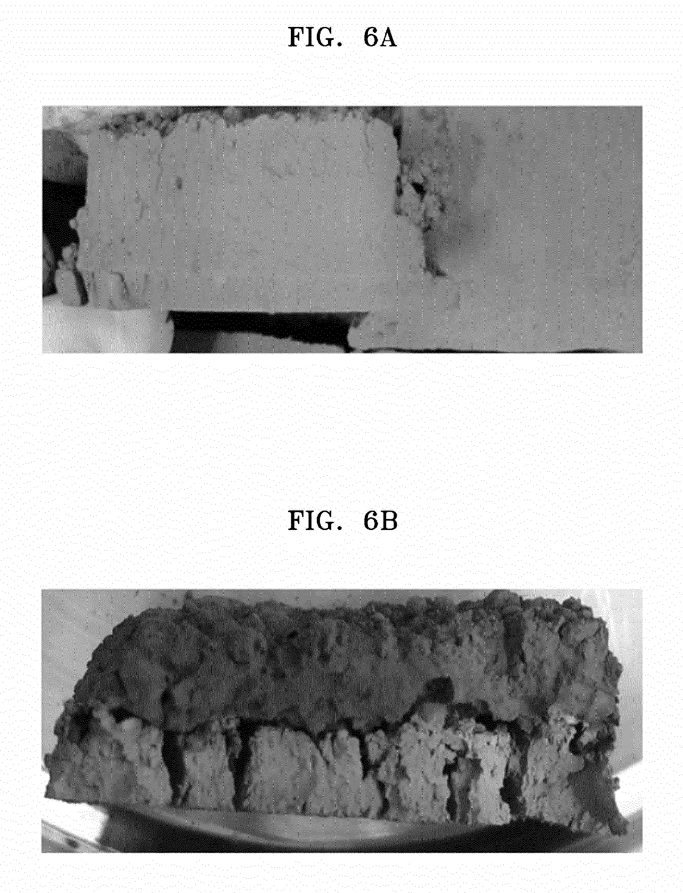

A charging test was performed on 5 kg of the first heat-treated product according to Example 1 and Comparative Example 2, and the test results are shown in Table 3, FIGS. 6A, and 6B. FIGS. 6A and 6B are views illustrating the separation of top and bottom in the case of using the product first heat treated according to Example 1 and Comparative Example 2, respectively.

Table 3

| Example | | | | 003 | 003/104 | 003/104 | |
|---|---|---|---|---|---|---|---|
| | | | Charging amount (Kg) | FWHM | Area | FWHM | Properties |
| Comparative Example 2 | small precursor (top) | | 4.97 | 0.116 | 1.188 | 0.87 | Separations of top and bottom |
| | small precursor (bottom) | | | 0.152 | 1.091 | 0.65 | Separations of top and bottom |
| Example 1 | Large pore precursors (Top) - Examples | | 5 | 0.120 | 0.134 | 0.90 | OK |
| | Large pore precursors (Bottom) - Examples | | | 0.122 | 0.137 | 0.89 | OK |

Referring to Table 3 and FIGS. 6A and 6B, when the product subjected to the first heat treatment according to Comparative Example 2 was used, small particle agglomerate was large, separations of top and bottom occurred, and aggregation occurred greatly, resulting in a difference in XRD properties.

On the other hand, when the large grain precursor of Example 1 was used, the product subjected to the first heat treatment did not show separations of top and bottom, aggregates were small, and there was no difference (substantially no difference) in XRD properties. Accordingly, it can be seen that when the large precursor of Example 1 was used, a uniform (substantially uniform) cathode active material layer having no difference in physical properties could be obtained, compared to the case using the small precursor of Comparative Example 2.

Evaluation Example 4: X-ray diffraction analysis

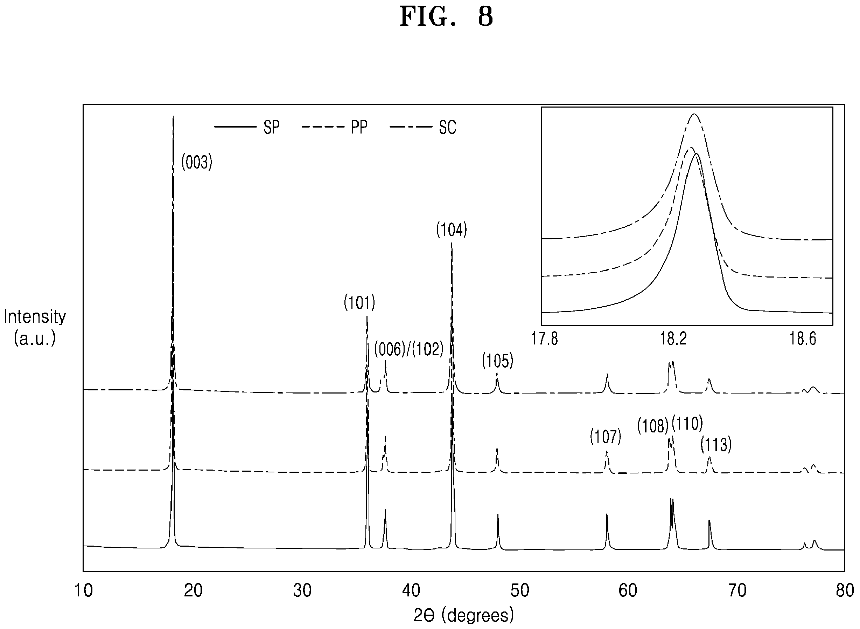

The SP, PP, and SC prepared according to Example 2 were subjected to X-ray diffraction analysis using X'pert pro (PANalytical) using Cu Kα radiation (1.54056Å). The results of X-ray diffraction analysis are shown in FIG. 8 and Table 4.

The crystal structure of the product in each process was analyzed by XRD characterization in FIG. 8. All samples from each process show the same diffraction peak corresponding to α-NaFeO$_2$ having the layered hexagonal structure. Peak splitting occurred clearly at (006)/(102) and (108)/(110). This result indicates or at least suggests the formation of a crystalline layered oxide structure. The frame of the layered oxide structure is maintained in each synthesis process from SP to SC, but the detailed crystal structures with respect to SP, PP and SC are slightly different from each other as shown in FIG. 8 and Table 4.

The shifting of the peak to a lower angle indicates that the well-crystallized SP particles collapsed in the PP due to the physical damage caused by the jet mill process. The FWHM of the (003) plane supports the crystal structure collapse in PP. The broadening of the FWHM may be derived mainly from the lack of crystallinity, which is depleted of the order of the lattice domains.

The loss of crystallinity from the pulverizing process can be recovered during the second heat treatment as observed from the FWHM and XRD properties of (003) plane of SC. The peak corresponding to the (003) plane shifts to the original position of the SP and the FWHM is decreased to similar value with SP exhibiting the defected crystal recovers its crystallinity. The Li/Ni disordering is decreased during the second heat treatment as the intensity ratio of (003) plane and (104) plane is increased to 1.21. The width ratio of (003) plane and (104) plane are also increased in SC. This result indicates or at least suggests that SC exhibits high crystallinity not only in the (003) plane direction but also in the (104) plane direction. XRD analysis results show that SC obtained according to the method described above had high crystallinity and low Li/Ni disordering.

In Table 4, I$_{(003)}$ indicates the intensity of the peak corresponding to the (003) plane (the peak having 2θ of about 18°-19°), and I$_{(104)}$ indicates the intensity of the peak corresponding to the (104) plane (the peak having 2θ of about 44.5°). In this regard, W$_{(003)}$ represents the FWHM of the peak corresponding to the (003) plane, and W$_{(104)}$ represents the FWHM of the peak corresponding to the (104) plane.

Table 4

|  | W$_{(003)}$ | I$_{(003)}$/I$_{(104)}$ | W$_{(003)}$/W$_{(104)}$ |
|---|---|---|---|
|  | FWHM$_{(003)}$ | Ratio | ratio |
| SP | 0.110 | 1.84 | 0.78 |
| PP | 0.121 | 1.09 | 0.70 |
| SC | 0.108 | 1.21 | 1.07 |

Evaluation Example 5: Mass Production Test

Charge/discharge characteristics of the coin half cells manufactured in Manufacture Example 3 and Comparative Manufacture Example 3 were evaluated using a charging/discharging apparatus (Model No.: TOYO-3100 available from TOYO).

In the first charge/discharge cycle, the coin half-cells were each charged at 25 °C at a constant current of 0.1 C until the voltage reached 4.25 V and then charged at a constant voltage until the current reached 0.05 C. Once the charging was completed, the cell was rested for about 10 minutes, and then discharged at a constant current of 0.1 C until the voltage reached 3 V. In the second charge/discharge cycle, the cells were each charged at a constant current of 0.2 C until the voltage reached 4.25 V and then charged at a constant voltage until the current reached 0.05 C. Once the charging was completed, the cell was rested for about 10 minutes, and then discharged at a constant current of 0.2 C until the voltage reached 3 V.

Evaluation of the lifespan of each of the coin half-cells was performed by charging the cell at a constant current of 1 C until the voltage reached 4.3 V and then charging the cell at a constant voltage until the current reached 0.05 C. Once the charging was completed, the cell was rested for about 10 minutes, and then discharged at a constant current of 1 C until the voltage reached 3 V. The charge/discharge cycle was repeated 50 times.

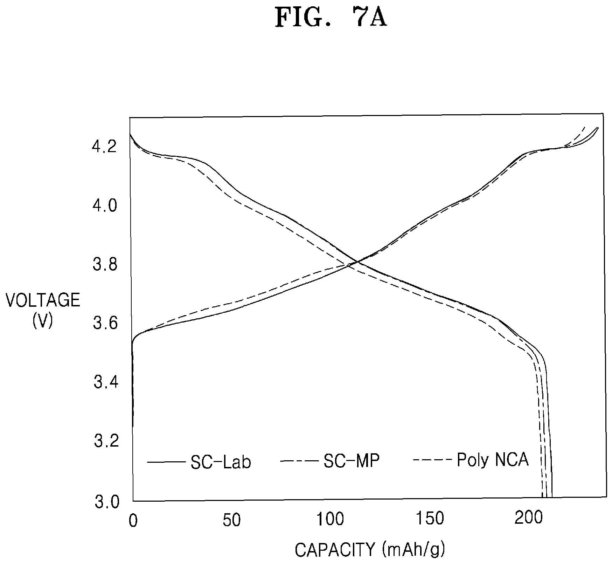

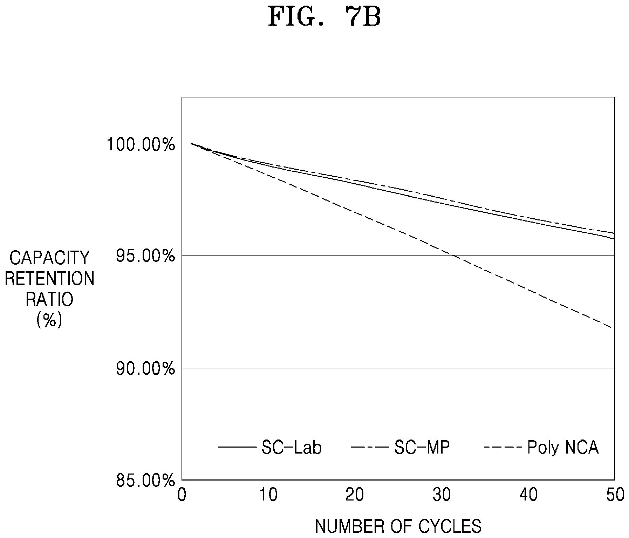

The capacity retention ratio (CRR) was calculated using Equation 2, and the charge/discharge efficiency was calculated from Equation 3. In addition, the CRR, charge/discharge efficiency characteristics, and battery capacity were evaluated and shown in FIGS. 7A and 7B. FIG. 7A shows the voltage change according to the capacity, and FIG. 7B shows the evaluation results of the capacity retention ratio.

Equation 2

CRR [%] = [discharge capacity in 50th cycle/discharge capacity in 1st cycle] X 100

Equation 3

Charging/discharging efficiency = [discharge voltage of 1st cycle / charging voltage of 1st cycle] X100

Referring to FIGS. 7A and 7B, SC-Lab and SC-MP used in Manufacture Example 3 showed stable discharge capacities of 211 mAh/g and 210 mAh/g, respectively. However, while the first cycle efficiency of SC is less than 89%, the efficiency of poly NCA (PC NCA) used in Comparative Manufacture Example 3 is more than 90%. These results are due to a long diffusion path of Li$^+$ ions through single grain (one-body particles)(>$\mu$m scale). Despite the loss of primary efficiency, both SC samples showed much better cycle retention properties after 50 cycles in which 96% of the initial discharge capacity was maintained, whereas poly NCA (PC NCA) showed 91 % of the capacity retention ratio after 50 cycles at the current rate of 1 C. Considering that SC-Lab and SC-MP exhibit similar electrochemical behavior, it can be seen that when the mass-production method of SC was used, material properties with excellent physical and electrochemical properties can be obtained.

Evaluation Example 6: Lifespan at a temperature of 45 °C

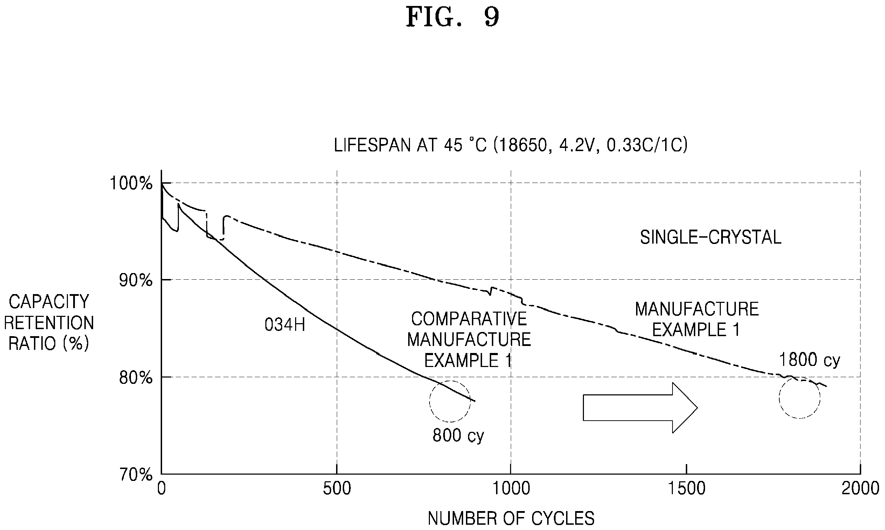

Charge/discharge characteristics of the coin half cells manufactured in Manufacture Example 1 and Comparative Manufacture Example 1 were evaluated using a charging/discharging apparatus (Model No.: TOYO-3100 available from TOYO).
In the first charge/discharge cycle, the coin half-cells were each charged at 45 °C at a constant current of 0.1 C until the voltage reached 4.25 V and then charged at a constant voltage until the current reached 0.05 C. Once the charging was completed, the cell was rested for about 10 minutes, and then discharged at a constant current of 0.1 C until the voltage reached 3 V. In the second charge/discharge cycle, the cells were each charged at a constant current of 0.2 C until the voltage reached 4.2 V and then charged at a constant voltage until the current reached 0.05 C. Once the charging was completed, the cell was rested for about 10 minutes, and then discharged at a constant current of 0.2 C until the voltage reached 3 V.
Evaluation of the lifespan of each of the coin half-cells was performed by charging the cell at a constant current of 1 C until the voltage reached 4.2 V and then charging the cell at a constant voltage until the current reached 0.05 C. Once the charging was completed, the cell was rested for about 10 minutes, and then discharged at a constant current of 1 C until the voltage reached 3 V. The charge/discharge cycle was repeated 2000 times.
The CRR characteristics of the battery were evaluated and results thereof are shown in FIG. 9.
Referring to FIG. 9, it can be seen that the coin half-cell of Preparation Example 1 had higher CRR than the coin half-cell of Comparative Preparation Example 1.

Evaluation Example 7: Evaluation of Physical and Structural Changes of Electrodes Before and After Cycles

(1) Manufacture Example 2 and Comparative Manufacture Example 3

Charge/discharge characteristics of the coin half-cells manufactured in Manufacture Example 2 and Comparative Manufacture Example 3 were evaluated using a charging/discharging apparatus (Model No.: TOYO-3100 available from TOYO).
In the first charge/discharge cycle, the coin half-cells were each charged at 25 °C at a constant current of 0.1 C until the voltage reached 4.25 V and then charged at a constant voltage until the current reached 0.05 C. Once the charging was completed, the cell was rested for about 10 minutes, and then discharged at a constant current of 0.1 C until the voltage reached 3 V. In the second charge/discharge cycle, the cells were each charged at a constant current of 0.2 C until the voltage reached 4.25 V and then charged at a constant voltage until the current reached 0.05 C. Once the charging was completed, the cell was rested for about 10 minutes, and then discharged at a constant current of 0.2 C until the voltage reached 3 V.
Evaluation of the lifespan of each of the coin cells was performed by charging the cell at a constant current of 1 C until the voltage reached 4.3 V and then charging the cell at a constant voltage until the current reached 0.05 C.

Once the charging was completed, the cell was rested for about 10 minutes, and then discharged at a constant current of 1 C until the voltage reached 3 V. This charge/discharge cycle was repeated 200 times. In addition, ex-situ XRD analysis was performed on the (003) peak of the cathode active material before and after 200 cycles at the cathode of Manufacture Example 2 and Comparative Manufacture Example 3.

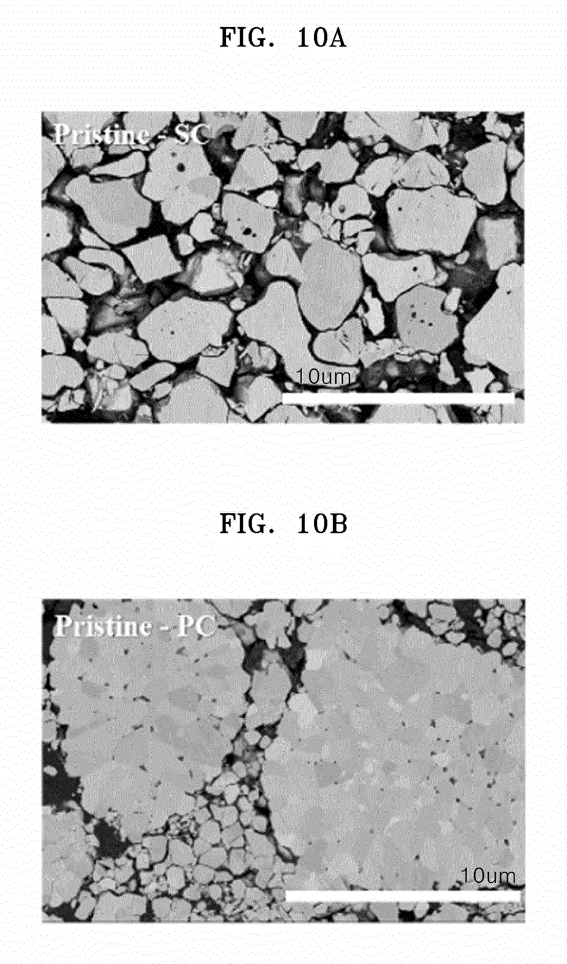

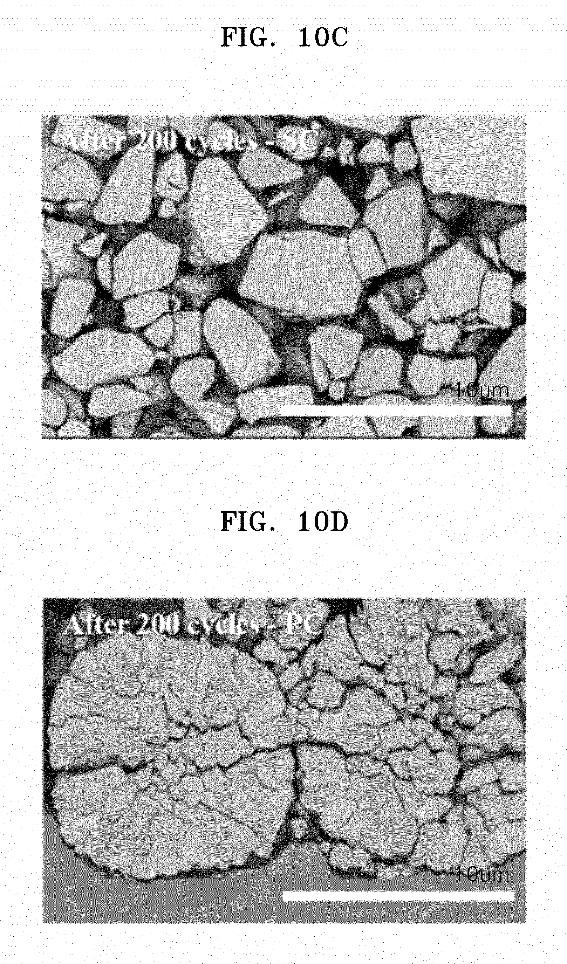

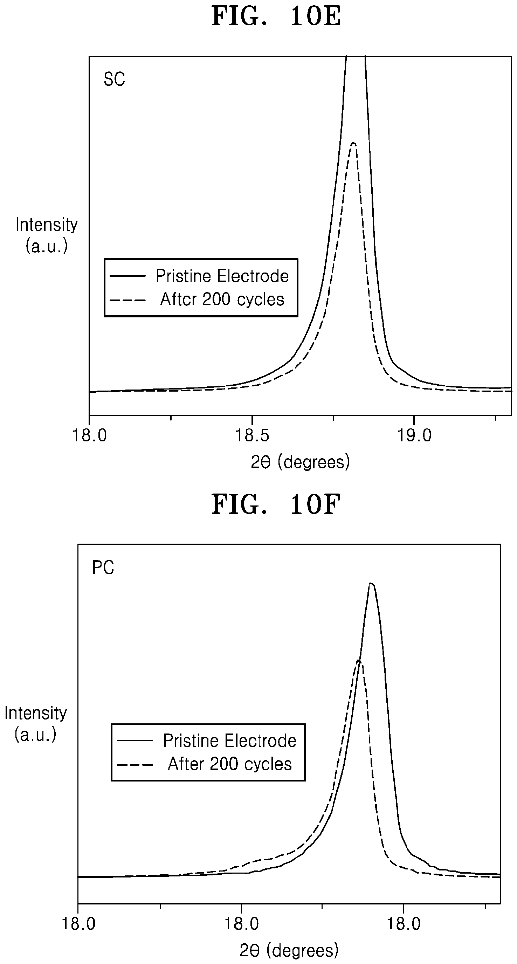

The morphology of the cathode before and after 200 cycles was analyzed using SEM. FIGS. 10A and 10B show SEM images of the cross-section of a cathode before a cycle in the batteries of Manufacture Example 2 and Comparative Manufacture Example 3, respectively, and FIGS. 10C and 10D show SEM images of the cross-section of a cathode after 200 cycles in the batteries of Manufacture Example 2 and Comparative Manufacture Example 3, respectively. FIGS. 10E and 10F show the results of ex-situ XRD analysis of the (003) peak of the cathode active material before and after 200 cycles at the cathode of Manufacture Example 2 and Comparative Manufacture Example 3, respectively.

The physical and structural changes of the Poly NCA (PC NCA) of Comparative Manufacture Example 3 and the SC NCA of Manufacture Example 2 are shown in FIGS. 10A to 10D. The SEM image of the cross-section of an electrode before and after cycling are shown in FIGS. 10A and 10B, and, in particular, ex-situ XRD focusing specifically on the (003) peak, are shown in FIGS. 10E and 10F. Referring to FIG. 10B, it can be seen that Poly NCA had primary particles having a particle size of 500 nm or less and secondary particles having a particle size of 14 $\mu$m.

After 200 cycles, the morphology collapses seriously as shown in FIG. 10D where cracks evolved through the grain boundaries of the primary particles of PC NCA. Because the formation of cracks causes SEI formation and disconnection of the electron pathway, the discharge capacity of PC NCA can be easily degraded during electrochemical cycling.

In contrast, SC NCA retains the grain morphology of pristine electrode even after 200 cycles as shown in FIG. 10C. Because single-crystals have a lower grain boundary than polycrystals, in the case of SC, fewer cracks are formed through the grain boundaries.

As can be seen from FIG. 10F, the ex-situ XRD of the cycled electrode shows a clear structural change of PC NCA, for example, the shift of the (003) main peak to a lower angle. The crystal structure of PC NCA is distorted by repeated insertion and extraction of Li$^+$ ions. However, SC NCA maintains the crystal structure even after 200 cycles as shown in FIG. 10C. The (003) peak of the SC electrode retains its peak position for 200 cycles as shown in FIG. 10E. This result indicates or at least suggests that there is almost no crystal structure change occurred in the SC electrode.

The single-crystal structure of NCA may withstand mechanical deformation due to expansion and contraction of the lattice during charging and discharging. Due to the narrower surface area of SC, reactions from surface such as SEI formation and NiO transformation can also be suppressed or reduced. Due to the excellent structural and morphological retention properties of SC, SC electrodes exhibit excellent or at least improved cycle retention properties.

(2) Manufacture Example 1 and Comparative Manufacture Example 1

In contrast, for the coin half cells of Manufacture Example 1 and Comparative Manufacture Example 1, the evaluation method in which the physical and structural changes of the cathode after the charge/discharge cycle for the coin half-cell of Manufacture Example 2 were identified, was performed in the same manner so as to evaluate the physical and structural changes of the cathode after the charge/discharge cycle.

As a result of the evaluation, it was confirmed that the morphology of the battery of Manufacture Example 1 did not change significantly after 200 cycles as in the case of Manufacture Example 2. In contrast, the coin half-cell of Comparative Manufacture Example 1 showed a change in morphology.

Evaluation Example 8: Full-cell performance test

The overwhelming cyclic performance of SC over poly crystal (PC) NCA was confirmed by a full cell test.

Manufacture Example 4: Full cell production

As a cathode, an SC mixed electrode (small SC NCA + large PC NCA in a 3:7 mixing weight ratio) and a PC mixed electrode (small PC NCA + large PC NCA in a 3:7 mixing weight ratio) were each formed, and then, full cells were manufactured by using the cathodes. In this regard, small SC NCA is the cathode active material of Example 2 formed from the nickel-based metal precursor of Preparation Example 2, large PC NCA is the cathode active material of Comparative Example 3 formed from the nickel-based metal precursor of Comparative Preparation Example 2, small PC NCA is the cathode active material of Comparative Example 2 formed from the nickel-based metal precursor of Comparative Preparation Example 3. The particle size of large PC NCA was about 14 $\mu$m, and the particle size of small SC NCA and small PC NCA were both about 3 $\mu$m.

A mixture of 96 g of cathode, 2 g of polyvinylidene fluoride, 47 g of N-methylpyrrolidone as a solvent, and 2 g of carbon black as a conductive agent was mixed by using a mixer to remove bubbles, thereby preparing a slurry for forming a cathode active material layer in which the mixture was homogeneously dispersed.

The slurry prepared according to the above process was coated on an aluminium foil by using a doctor blade to form a thin electrode plate, and then dried for 3 hours or more at 135 °C, followed by pressing and vacuum drying to complete the manufacture of a cathode.

98 wt% of synthetic graphite (BSG-L, Tianjin BTR New Energy Technology Co., Ltd.), 1.0 wt% of styrene-butadiene rubber (SBR) binder (ZEON), and 1.0 wt% of carboxymethylcellulose (CMC, NIPPON A&L) were mixed and then added to distilled water and stirred for 60 minutes using a mechanical stirrer to prepare an anode active material slurry. The slurry was applied to a thickness of about 60 $\mu$m on a copper current collector having a thickness of 10 $\mu$m by using a doctor blade, dried in a hot air dryer at 100 °C for 0.5 hours, and then dried again under vacuum and at a temperature of 120 °C for 4 hours, followed by roll pressing, thereby manufacturing an anode.

A full cell was prepared using the anode and the cathode. A separator having a thickness of about 16 $\mu$m and formed of a porous polyethylene (PE) film was placed between the cathode and the anode, and an electrolyte solution was injected to manufacture a 2032 type coin cell. A solution in which 1.1 M $LiPF_6$ was dissolved in a solvent in which ethylene carbonate (EC) was mixed with ethylmethyl carbonate (EMC) at a volume ratio of 3:5, was used as the electrolyte solution.

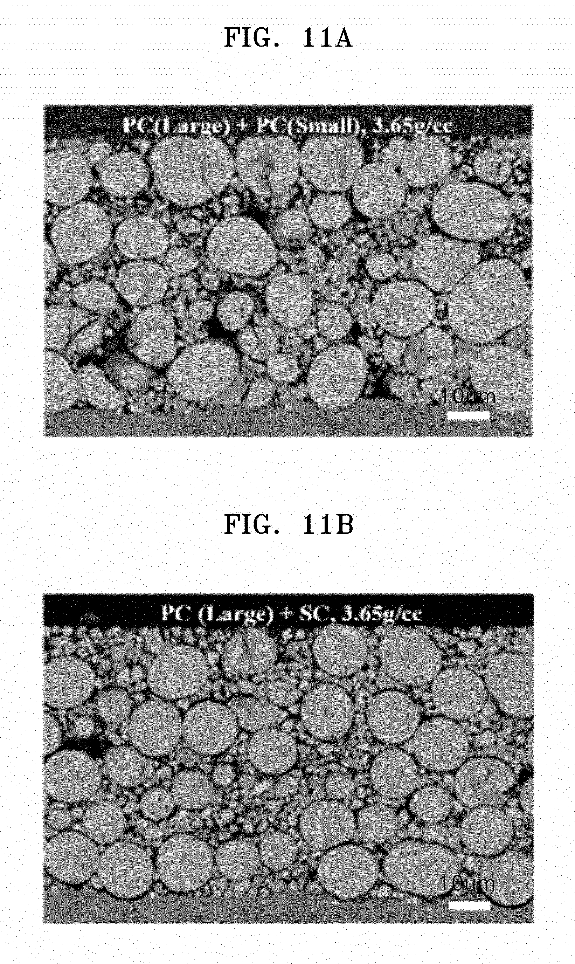

The excellent electrochemical activity of SC was confirmed by mixing each of small PC NCA and small SC NCA with large grain PC NCA to form a SC mixed electrode and a PC mixed electrode, each of which is a bimodal electrode. Such a bimodal electrode exhibits increased electrode density and the amount of the binder may be reduced. In this regard, the mixed weight ratio of large PC and SC is 70 wt%:30 wt%, and the weight ratio of the counter electrode blended with small PC is the same. In order to equalize the titration of the current density applied to each electrode, the two blend electrodes were calendared at an electrode density of 3.65 g/cc as shown in FIGS. 11A and 11B.

FIG. 11A shows an image of a full cell having a PC mixed electrode, and FIG. 11B shows an image of a full cell having an SC mixed electrode.

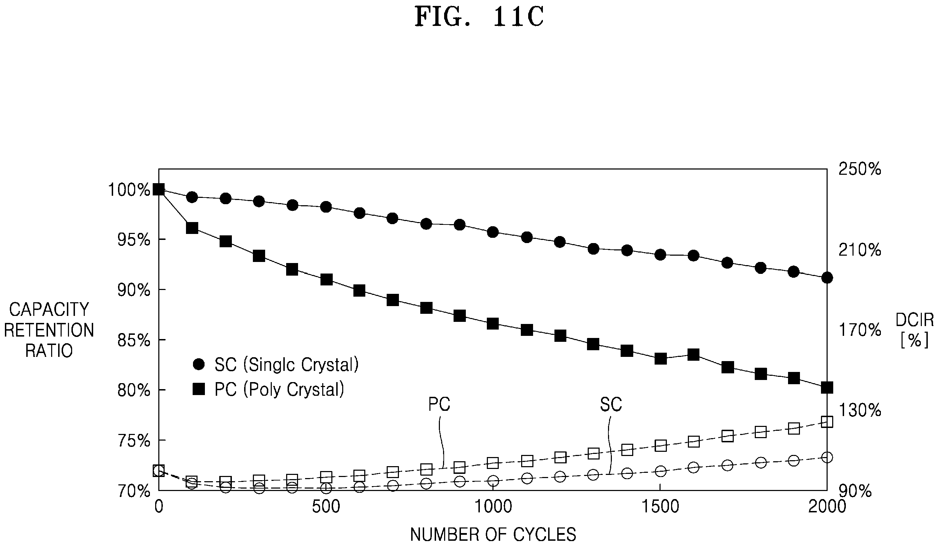

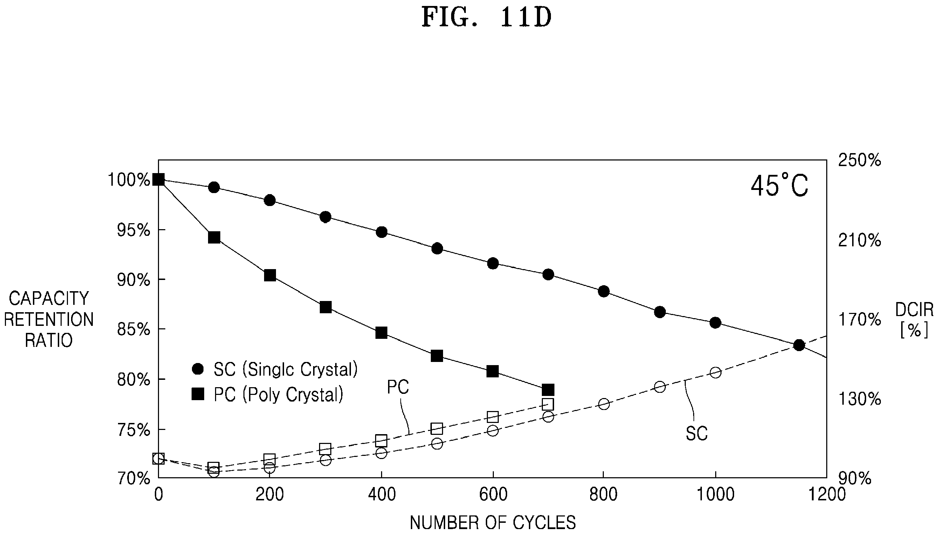

The SC mixed electrode (small SC NCA + large PC NCA) showed a large discharge capacity retention ratio of 91.4% after 2000 cycles at 25 °C (RT), whereas the PC mixed electrode (small particle PC (3 $\mu$m or less) +large (14 $\mu$m or less) PC NCA) had only 80% capacity retention as shown in FIG. 11C. The good cycle performance of the SC electrode is also shown in the high temperature test (45 °C) in FIG. 11D. In this regard, after 700 cycles, the SC electrode had the capacity retention ratio of 90.3%, while the PC electrode had the capacity retention ratio of 78.9%. Although the capacity retention of the SC electrode was decreased slightly as the cycle progresses, even after 1000 cycles, the capacity retention was maintained at 80.4%. This cycle performance is considered as being good, given that the cycling proceeded at a high temperature. DC-IR changes through cycling for RT(25 °C) and HT(45 °C) are smaller in SC than in PC, as can be seen in FIGS. 11C and 11D.

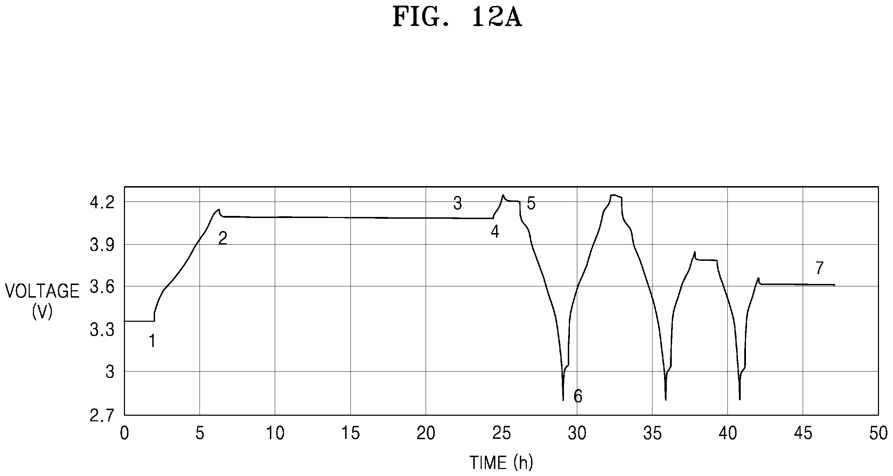

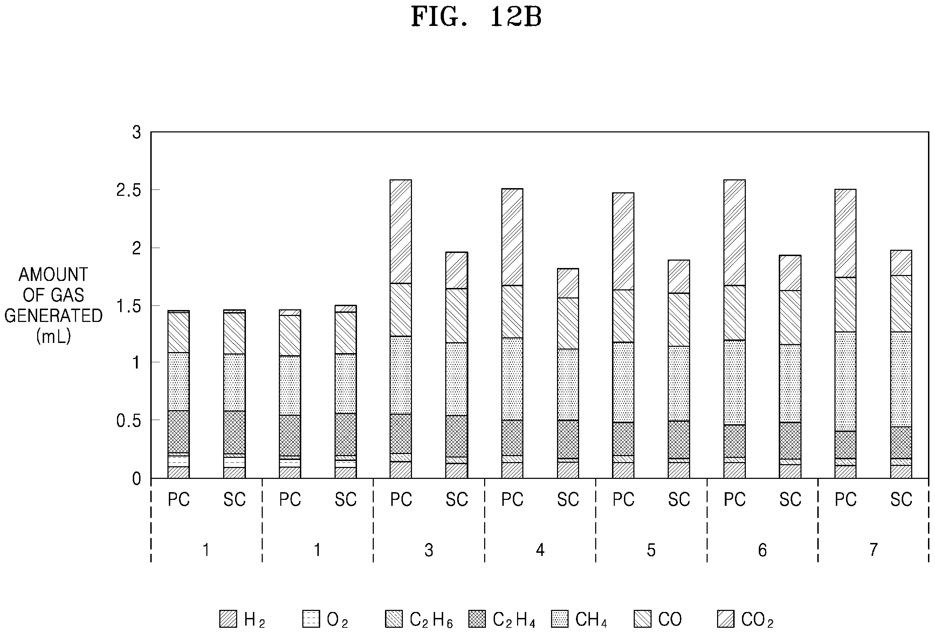

In addition, the manufacturing process of SC and PC-blend full cell was analyzed using in-situ chromatography, and the results are shown in FIGS. 12A and 12B. The formation process at each point is as shown in FIG. 12A. (1) after degassing, (2) SOC 80% at 0.2 C (4.15 V), (3) after 12 hours of resting at 45 °C, (4) 4 hours of another resting at 25 °C, (5) SOC 100% at 1/3 C (4.25 V), (6) SOC 0% at 1/3 C (2.8 V), and (7) after formation of SOC 30% at 1/3 C.

Both SC and PC cells showed similar gas generation behavior through the formation process and generated $CO_2$ gas. Referring to FIG. 12B, both SC and PC cells released $CO_2$, and (2) after SOC 80%, $CO_2$ gas was produced 3.5 times less in SC cells than in PC cells. The result that SC materials form much less $CO_2$ than PC, indicates that the SC material exhibits a lower oxidation activity with respect to an electrolyte, compared to PC during cycling.

When gas emissions are reduced using SC materials, large-scale batteries with improved safety can be developed. In general, in large-scale batteries, such as EVs or ESSs, gas emissions are a major obstacle. By using a single-crystal material, a battery having not only a long lifespan but also the enhanced safety can be obtained.

The cathode active material for a lithium secondary battery according to an aspect of one or more embodiments of the present disclosure has a single-crystal characteristic capable of high capacity, and when the cathode active material is used, a lithium secondary battery having improved long life cycle stability is able to be manufactured in mass production.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims, and equivalents thereof.

**Claims**

1. A cathode active material for a lithium secondary battery, the cathode active material comprising:

   a nickel-based lithium metal oxide containing single-crystal particles, wherein
   a particle size of the single-crystal particles is about 1 $\mu$m to about 8 $\mu$m, and
   a particle size distribution of the cathode active material expressed by (D90-D10)/D50 is 1.4 or less.

2. The cathode active material of claim 1, wherein
   the particle size distribution is about 1.0 to about 1.4.

3. The cathode active material of claim 1 or claim 2, wherein:

   (i) the D50 of the cathode active material is about 2 $\mu$m to about 4 $\mu$m; and/or
   (ii) the D10 of the cathode active material is about 1.2 $\mu$m to about 2 $\mu$m, and D90 of the cathode active material is about 4 $\mu$m to about 7 $\mu$m.

4. The cathode active material of any one of claims 1 to 3, wherein

   the nickel-based lithium metal oxide is a compound represented by Formula 1:

   $$\text{Formula 1} \qquad Li_a(Ni_{1-x-y}M1_xM2_y)O_{2\pm\alpha1}$$

   wherein, in Formula 1, M1 is at least one element selected from Co, Mn, and Al,

   M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and
   $0.95 \leq a \leq 1.1$, $0.6 \leq (1-x-y) < 1$, $0 \leq x < 0.4$, $0 \leq y < 0.4$, and $0 \leq \alpha1 \leq 0.1$, wherein a case where both x and y are 0 excluded, optionally wherein:

   the nickel-based lithium metal oxide is a compound represented by Formula 2:

   $$\text{Formula 2} \qquad Li_a(Ni_{1-x-y-z}Co_xM3_yM4_z)O_{2\pm\alpha1}$$

   wherein, in Formula 2, M3 is at least one element selected from Mn and Al,

   M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and
   $0.95 \leq a \leq 1.1$, $0.6 \leq (1-x-y-z) < 1$, $0 \leq x < 0.4$, $0 \leq y < 0.4$, $0 \leq z < 0.4$, and $0 \leq \alpha1 \leq 0.1$, wherein a case where x, y, and z are each 0, is excluded.

5. The cathode active material of any one of claims 1 to 4, wherein:

   (i) the particle size of the single-crystal particles is about 2 $\mu$m to about 6 $\mu$m; and/or
   (ii) the cathode active material further comprises an aggregate of 10 or fewer primary particles.

6. The cathode active material of any one of claims 1 to 5, wherein:

   (i) $I_{(003)}/I_{(104)}$, which is a peak intensity ratio measured by X-ray diffraction analysis, is about 1.2 to about 4.0; and/or
   (ii) $W_{(003)}/W_{(104)}$ obtained in X-ray diffraction analysis of the cathode active material is about 1.01 to about 1.09.

7. The cathode active material of any one of claims 1 to 6, wherein:

   (i) the cathode active material further comprises a cobalt compound-containing coating layer on a surface of the nickel-based lithium metal oxide, optionally wherein an amount of a cobalt compound included in the cobalt compound-containing coating layer is about 0.1 mol% to about 5.0 mol% based on the total amount of the cathode active material; and/or

(ii) a thickness of the cobalt compound-containing coating layer is about 1 nm to about 50 nm; and/or

(iii) a cobalt compound included in the cobalt compound-containing coating layer is cobalt oxide, lithium cobalt oxide, or a combination thereof; and/or

(iv) the cobalt compound-containing coating layer further comprises at least one element selected from boron, manganese, phosphorus, aluminium, zinc, zirconium, and titanium.

8. A method of preparing a cathode active material for a lithium secondary battery, the method comprising:

obtaining a nickel-based metal precursor having pores therein by a co-precipitation reaction of a nickel precursor and at least one compound selected from an M1 precursor and an M2 precursor, and then drying the resultant;

obtaining a mixture of the nickel-based metal precursor having pores therein and a lithium precursor;

performing a first heat treatment on the mixture to obtain porous oxide particles; and

pulverizing the porous oxide particles,

wherein the M1 precursor is at least one compound selected from a cobalt precursor, a manganese precursor, and an aluminium precursor, and

the M2 precursor is a precursor including at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr).

9. The method of claim 8, wherein

the co-precipitation reaction is performed using a complexing agent and a pH-adjusting agent, and the complexing agent is aqueous ammonia, citric acid, or a combination thereof, and

the pH-adjusting agent is sodium hydroxide (NaOH), sodium carbonate ($Na_2CO_3$), sodium oxalate ($Na_2C_2O_4$), or a combination thereof.

10. The method of claim 8 or claim 9, further comprising performing a second heat treatment after the pulverizing, wherein the first heat treatment is performed at a higher temperature than the second heat treatment, optionally wherein: the second heat treatment is performed in an oxidizing gas atmosphere, at a temperature of 600 °C to 900 °C.

11. The method of any one of claims 8 to 10, wherein

the nickel-based metal precursor having pores therein has an amorphous state, and the nickel-based metal precursor is a secondary particle, and

a particle size of the secondary particle is about 7 $\mu$m to about 20 $\mu$m.

12. The method of any one of claims 8 to 11, wherein:

(i) the nickel-based metal precursor having pores is a compound represented by Formula 3, a compound represented by Formula 4, or a combination thereof:

Formula 3          $(Ni_{1-x-y}M1_xM2_y)(OH)_2$

wherein, in Formula 3, M1 is at least one element selected from Co, Mn, and Al,

M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y) < 1$, $0 \leq x < 0.4$, and $0 \leq y < 0.4$, wherein a case where both x and y are 0 is excluded,

Formula 4          $(Ni_{1-x-y}M1_xM2_y)O$

wherein, in Formula 4, M1 is at least one element selected from Co, Mn, and Al,

M2 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y) < 1$, $0 \leq x < 0.4$, and $0 \leq y < 0.4$, wherein a case where both x and y are 0 is excluded; or

(ii) the nickel-based metal precursor having pores is a compound represented by Formula 5, a compound represented by Formula 6, or a combination thereof:

Formula 5 $Ni_{1-x-y-z}Co_xM3_yM4_z(OH)_2$

wherein, in Formula 5, M3 is at least one element selected from Mn and Al,

M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, and $0 \leq z < 0.4$, wherein a case where x, y, and z are each 0, is excluded,

Formula 6 $(Ni_{1-x-y-z}Co_xM3_yM4_z)O$

wherein, in Formula 6, M3 is at least one element selected from Mn and Al,

M4 is at least one element selected from boron (B), magnesium (Mg), calcium (Ca), strontium (Sr), barium (Ba), titanium (Ti), vanadium (V), chromium (Cr), iron (Fe), copper (Cu), and zirconium (Zr), and $0.6 \leq (1-x-y-z) < 1$, $0 \leq x < 0.4$, $0 \leq y < 0.4$, and $0 \leq z < 0.4$, wherein a case where x, y, and z are each 0, is excluded.

13. The method of any one of claims 8 to 12, wherein

(i) the nickel-based metal precursor having pores and the lithium precursor are mixed such that a molar ratio (Li/Me) of Li to metals other than Li is 0.9 or more and less than 1.1; and/or
(ii) the lithium precursor is lithium hydroxide, lithium carbonate, lithium sulfate, lithium nitrate, or a combination thereof; and/or
(iii) the first heat treatment is performed in an oxidizing gas atmosphere, at a temperature of 800 °C to 1200 °C.

14. The method of any one of claims 8 to 13, further comprising, after the pulverizing, obtaining a mixture by adding a cobalt precursor to a pulverized product, optionally wherein:
the cobalt precursor is $Co(OH)_2$, CoOOH, CoO, $Co_2O_3$, $Co_3O_4$, $CO(OCOCH_3)_2 \cdot 4H_2O$, $CoCl_2$, $Co(NO_3)_2 \cdot 6H_2O$, $CoSO_4$, $Co(SO_4)_2 \cdot 7H_2O$, or a combination thereof.

15. A lithium secondary battery comprising: a cathode containing the cathode active material of any one of claims 1 to 7;

an anode; and
an electrolyte located between the cathode and the anode.

# FIG. 1

| POROUS NICKEL-BASED METAL PRECURSOR | Hollow & Crystallized Secondary Particle (SP) | Surface Defected Primary particle (PP) | SINGLE-CRYSTAL CATHODE ACTIVE MATERIAL (SC) |

## FIG. 2A

SDI 5.0kV 8.7mm x10.0k SE(M)                     5.00um

## FIG. 2B

SDI 5.0kV 8.5mm x5.00k SE(M)                     10.0um

## FIG. 2C

SDI 5.0kV 9.0mm x5.00k SE(M)                    10.0um

## FIG. 2D

SDI 5.0kV 7.7mm x5.00k SE(M)                    10.0um

## FIG. 3A

5um

## FIG. 3B

SDI 5.0kV 8.8mm x10.0k SE(M)          5.00um

# FIG. 3C

Mag=10.00 K X  2um  WD=4.0 mm EHT=3.00 kV
Brightness=38.0%  Contrast=80.0%

## FIG. 4A

## FIG. 4B

# FIG. 4C

# FIG. 4D

# FIG. 5A

EP 4 144 703 A1

# FIG. 5B

# FIG. 5C

## FIG. 6A

## FIG. 6B

# FIG. 7A

# FIG. 7B

EP 4 144 703 A1

# FIG. 8

EP 4 144 703 A1

## FIG. 9

LIFESPAN AT 45 °C (18650, 4.2V, 0.33C/1C)

# FIG. 10A

# FIG. 10B

## FIG. 10C

## FIG. 10D

## FIG. 10E

SC

Intensity (a.u.)

— Pristine Electrode
--- Aftcr 200 cycles

2θ (degrees)

18.0    18.5    19.0

## FIG. 10F

PC

Intensity (a.u.)

— Pristine Electrode
--- After 200 cycles

2θ (degrees)

18.0    18.0    18.0

# FIG. 11A

# FIG. 11B

# FIG. 11C

EP 4 144 703 A1

FIG. 12A

FIG. 12B

EP 4 144 703 A1

# FIG. 13

Europäisches
Patentamt

European
Patent Office

Office européen
des brevets

# EUROPEAN SEARCH REPORT

Application Number

EP 22 19 3247

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/143423 A1 (PAULSEN JENS [KR] ET AL) 13 May 2021 (2021-05-13) * paragraphs [0175] – [0178]; examples; tables * ----- | 1-15 | INV. C01G53/00 H01M4/525 |
| X | US 2020/313183 A1 (KADOWAKI TAKUYA [JP] ET AL) 1 October 2020 (2020-10-01) * paragraphs [0485] – [0486]; examples 2-3,6; tables * ----- | 1-15 | |
| A | US 2021/210757 A1 (HOSONO AKARI [JP] ET AL) 8 July 2021 (2021-07-08) * tables 1-2 * ----- | 1-15 | |

TECHNICAL FIELDS
SEARCHED      (IPC)

C01G
H01M

The present search report has been drawn up for all claims

| Place of search | Date of completion of the search | Examiner |
|---|---|---|
| Munich | 25 January 2023 | Marucci, Alessandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................................
& : member of the same patent family, corresponding document

EPO FORM 1503 03.82 (P04C01)

**EP 4 144 703 A1**

## ANNEX TO THE EUROPEAN SEARCH REPORT
## ON EUROPEAN PATENT APPLICATION NO.

EP 22 19 3247

This annex lists the patent family members relating to the patent documents cited in the above-mentioned European search report.
The members are as contained in the European Patent Office EDP file on
The European Patent Office is in no way liable for these particulars which are merely given for the purpose of information.

25-01-2023

| Patent document cited in search report | | Publication date | Patent family member(s) | | Publication date |
|---|---|---|---|---|---|
| US 2021143423 | A1 | 13-05-2021 | CN | 112004779 A | 27-11-2020 |
| | | | EP | 3774661 A1 | 17-02-2021 |
| | | | HU | E059418 T2 | 28-11-2022 |
| | | | JP | 7202393 B2 | 11-01-2023 |
| | | | JP | 2021517721 A | 26-07-2021 |
| | | | KR | 20200138795 A | 10-12-2020 |
| | | | PL | 3774661 T3 | 19-09-2022 |
| | | | US | 2021143423 A1 | 13-05-2021 |
| | | | WO | 2019185349 A1 | 03-10-2019 |
| US 2020313183 | A1 | 01-10-2020 | NONE | | |
| US 2021210757 | A1 | 08-07-2021 | CN | 112740442 A | 30-04-2021 |
| | | | EP | 3855541 A1 | 28-07-2021 |
| | | | JP | 6669920 B1 | 18-03-2020 |
| | | | JP | 2020053386 A | 02-04-2020 |
| | | | KR | 20210058959 A | 24-05-2021 |
| | | | US | 2021210757 A1 | 08-07-2021 |

EPO FORM P0459

For more details about this annex : see Official Journal of the European Patent Office, No. 12/82